# EUROPEAN PATENT APPLICATION

(11) **EP 2 515 329 A1**
(43) Date of publication of application: **24.10.2012**
(21) Application number: 10837546.0
(22) Date of filing: 13.12.2010
(51) Int. Cl.: H01L 21/56, H01L 23/12

(54) **METHOD FOR PRODUCING ELECTRONIC DEVICE, ELECTRONIC DEVICE, METHOD FOR PRODUCING ELECTRONIC DEVICE PACKAGE, AND ELECTRONIC DEVICE PACKAGE**

(30) Priority: 14.12.2009 JP 2009282818
(71) Applicant: Sumitomo Bakelite Co., Ltd., Shinagawa-ku Tokyo 140-0002 (JP)
(72) Inventor: KUSUNOKI Junya, Tokyo 140-0002 (JP); TAKEUCHI Etsu, Tokyo 140-0002 (JP); SUGIYAMA Hiromichi, Tokyo 140-0002 (JP); KUBOYAMA Toshiharu, Tokyo 140-0002 (JP); KAWATA Masakazu, Tokyo 140-0002 (JP); NIKAIDO Hiroki, Tokyo 140-0002 (JP); MAEDA Masakatsu, Tokyo 140-0002 (JP)
(74) Representative: Müller-Boré & Partner Patentanwälte
(86) International application number: PCT/JP2010/072341
(87) International publication number: WO 2011/074520

(57) **Abstract**

A method of producing an electronic device includes an immobilizing resin layer-forming step that includes forming an immobilizing resin layer on a surface of a support substrate, an electronic part-immobilizing step that includes disposing a plurality of electronic parts on the immobilizing resin layer so that a space is formed between adjacent electronic parts among the plurality of electronic parts to immobilize the plurality of electronic parts on the support substrate via the immobilizing resin layer, a encapsulating material layer-forming step that includes covering the plurality of electronic parts with a encapsulating material to form a encapsulating material layer on the immobilizing resin layer and the plurality of electronic parts, a encapsulating material-curing step that includes curing the encapsulating material by heating the encapsulating material to obtain a encapsulating material cured product which is supported on the support substrate and in which the plurality of electronic parts are disposed, and a removal step that includes removing the encapsulating material cured product supported on the support substrate from the support substrate, the removal step removing the encapsulating material cured product from the support substrate by reducing a molecular weight of a resin included in the immobilizing resin layer. This method ensures that the encapsulating material and the electronic parts are rarely damaged, and a residue can be easily removed when producing a redistribution-type electronic device.

## Description

### TECHNICAL FIELD

The invention relates to a method of producing an electronic device, an electronic device, a method of producing an electronic device package, and an electronic device package.

### BACKGROUND ART

In recent years, an electronic part (e.g., semiconductor chip) provided with an integrated circuit has been used for various applications, and required to have various functions. An increase in throughput and an increase in processing speed have been desired, and the number of wires of semiconductor chips has increased along with an increase in the density of semiconductor chips. However, the wiring pitch is limited, and the number of I/O wires is determined depending on the area of each semiconductor chip. Therefore, the number of wires has been limited.

A chip-on-chip (COC) technique that electrically stacks semiconductor chips has been proposed to solve the above problems and implement high-density mounting. However, the COC technique may not be able to achieve a high yield when stacking semiconductor chips, or may result in poor connection reliability.

In view of the above situation, a redistribution-type electronic device has been proposed (see Patent Document 1, for example). More specifically, an adhesive layer is formed on a support substrate, and diced electronic parts (e.g., semiconductor chips) are immobilized on the adhesive layer at intervals. A encapsulating material (e.g., semiconductor encapsulating material) is provided to cover the electronic parts, and a cured product of the encapsulating material in which the electronic parts are disposed is removed from the adhesive layer. Wires are provided on the side of each electronic part that has come in contact with the adhesive layer so as to reach an area outside each electronic part using a redistribution technique to achieve an increase in number of I/O wires and density.

The adhesive layer used for the redistribution-type electronic device is required to secure each electronic part on the support substrate so that each electronic part is not displaced at the encapsulating temperature of the encapsulating material. The adhesive layer is also required to ensure that a cured product of the encapsulating material in which the electronic parts are disposed can be easily removed from the support substrate on which the adhesive layer is formed after thermally curing the encapsulating material. It is also desirable that a residue of the adhesive layer does not adhere to the cured product of the encapsulating material.

However, since a related-art adhesive layer is a thermoplastic adhesive layer or a thermally foaming adhesive layer, it is difficult to simultaneously achieve a function that reliably immobilizes electronic parts, a function that easily removes a cured product of a encapsulating material from a support substrate, and a function that prevents adhesion of a residue (see Patent Documents 2 and 3, for example).

If displacement of electronic parts has occurred, the subsequent redistribution process may be hindered. If a cured product of the encapsulating material cannot be easily removed, breakage (e.g., cracks) of the encapsulating material and the electronic parts may occur. If a residue of the adhesive layer adheres to a cured product of the encapsulating material in which the electronic parts are disposed, the reliability of the electronic device decreases.

### RELATED-ART DOCUMENT

### NON-PATENT DOCUMENT

Patent Document 1: JP-A-2006-287235
Patent Document 2: JP-A-2005-191296
Patent Document 3: JP-A-2005-243702

### SUMMARY OF THE INVENTION

### TECHNICAL PROBLEM

An object of the invention is to provide a method of producing an electronic device that prevents displacement of electronic parts during production of a redistribution-type electronic device, suppresses breakage of a encapsulating material and electronic parts, and can conveniently remove a residue, a highly reliable electronic device produced by the above method, a method of producing an electronic device package including the above method, and a highly reliable electronic device package produced by the above method.

### SOLUTION TO PROBLEM

The above object may be achieved by the following method and the like (see (1) to (22)).
(1) A method of producing an electronic device including:
   an immobilizing resin layer-forming step that includes forming an immobilizing resin layer on a surface of a support substrate;
   an electronic part-immobilizing step that includes disposing a plurality of electronic parts on the immobilizing resin layer so that a space is formed between adjacent electronic parts among the plurality of electronic parts to immobilize the plurality of electronic parts on the support substrate via the immobilizing resin layer;
   a encapsulating material layer-forming step that includes covering the plurality of electronic parts with a encapsulating material to form a encapsulating material layer on the immobilizing resin layer and the plurality of electronic parts;
   a encapsulating material-curing step that includes curing the encapsulating material by heating the encapsulating material to obtain a encapsulating material cured product which is supported on the support substrate and in which the plurality of electronic parts are disposed; and
   a removal step that includes removing the encapsulating material cured product supported on the support substrate from the support substrate,
   the removal step removing the encapsulating material cured product from the support substrate by reducing a molecular weight of a resin included in the immobilizing resin layer.
(2) The method of producing an electronic device according to (1), wherein the removal step includes removing the encapsulating material cured product from the support substrate by heating the immobilizing resin layer to thermally decompose the immobilizing resin layer.
(3) The method of producing an electronic device according to (1), wherein the removal step includes applying active energy rays to the immobilizing resin layer, and removing the encapsulating material cured product from the support substrate by heating the immobilizing resin layer to thermally decompose the immobilizing resin layer.
(4) The method of producing an electronic device according to (1), wherein the removal step includes applying active energy rays to the immobilizing resin layer, and removing the encapsulating material cured product from the support substrate by heating the immobilizing resin layer to melt the immobilizing resin layer.
(5) The method of producing an electronic device according to any one of (1) to (4), wherein a temperature at which the encapsulating material is heated in the encapsulating material-curing step is lower than a temperature at which the immobilizing resin layer is heated in the removal step.
(6) The method of producing an electronic device according to (3) or (4), wherein the temperature at which the immobilizing resin layer is heated in the removal step is 130 to 200°C.
(7) The method of producing an electronic device according to (4), wherein the immobilizing resin layer to which the active energy rays have been applied has a melt viscosity at 180°C of 0.01 to 100 Pa·s.
(8) A method of producing an electronic device including:
   an immobilizing resin layer-forming step that includes forming an immobilizing resin layer on a surface of a support substrate;
   an electronic part-immobilizing step that includes disposing a plurality of electronic parts on the immobilizing resin layer so that a space is formed between adjacent electronic parts among the plurality of electronic parts to immobilize the plurality of electronic parts on the support substrate via the immobilizing resin layer;
   a encapsulating material layer-forming step that includes covering the plurality of electronic parts with a encapsulating material to form a encapsulating material layer on the immobilizing resin layer and the plurality of electronic parts; and
   a encapsulating material-curing/removal step that includes curing the encapsulating material by heating the encapsulating material to obtain a encapsulating material cured product which is supported on the support substrate and in which the plurality of electronic parts are disposed, and removing the encapsulating material cured product from the support substrate,
   the encapsulating material-curing/removal step removing the encapsulating material cured product from the support substrate by reducing a molecular weight of a resin included in the immobilizing resin layer.
(9) The method of producing an electronic device according to (8), wherein the encapsulating material-curing/removal step includes removing the encapsulating material cured product from the support substrate by heating the immobilizing resin layer to thermally decompose the immobilizing resin layer.
(3) The method of producing an electronic device according to (8), wherein the encapsulating material-curing/removal step includes applying active energy rays to the immobilizing resin layer, and removing the encapsulating material cured product from the support substrate by heating the immobilizing resin layer to thermally decompose the immobilizing resin layer.
(11) The method of producing an electronic device according to (8), wherein the encapsulating material-curing/removal step includes applying active energy rays to the immobilizing resin layer, and removing the encapsulating material cured product from the support substrate by heating the immobilizing resin layer to melt the immobilizing resin layer.
(12) The method of producing an electronic device according to (10) or (11), wherein the temperature at which the encapsulating material and the immobilizing resin layer are heated in the encapsulating material-curing/removal step is 130 to 200°C.
(13) The method of producing an electronic device according to (11), wherein the immobilizing resin layer to which the active energy rays have been applied has a melt viscosity at 180°C of 0.01 to 100 Pa·s.
(14) The method of producing an electronic device according to any one of (1) to (13), further including a wiring layer-forming step that includes forming a wiring layer on a side of the encapsulating material cured product on which the plurality of electronic parts are exposed to obtain the encapsulating material cured product on which the wiring layer is formed.
(15) The method of producing an electronic device according to (14), further including a dicing step that includes dicing the encapsulating material cured product on which the wiring layer is formed.
(16) The method of producing an electronic device according to (3) or (10), wherein the immobilizing resin layer includes a resin that decreases in thermal decomposition temperature in the presence of an acid or a base, and a photoacid generator that generates an acid upon application of the active energy rays or a photobase generator that generates a base upon application of the active energy rays.
(17) The method of producing an electronic device according to (4) or (11), wherein the immobilizing resin layer includes a resin that decreases in melting temperature in the presence of an acid or a base, and a photoacid generator that generates an acid upon application of the active energy rays or a photobase generator that generates a base upon application of the active energy rays.
(18) The method of producing an electronic device according to (16) or (17), wherein the resin is a polycarbonate resin.
(19) The method of producing an electronic device according to (18), wherein the polycarbonate resin includes a carbonate structural unit that includes at least two cyclic structures.
(20) An electronic device produced by the method of producing an electronic device according to any one of (1) to (19).
(21) A method of producing an electronic device package including mounting the diced encapsulating material cured product according to (15) on a substrate.
(22) An electronic device package produced by the method of producing an electronic device package according to (21).

### ADVANTAGEOUS EFFECTS OF THE INVENTION

It is thus possible to provide a method of producing an electronic device that prevents displacement of electronic parts during production of a redistribution-type electronic device, suppresses breakage of a encapsulating material and electronic parts, and can conveniently remove a residue, a highly reliable electronic device produced by the above method, a method of producing an electronic device package including the above method, and a highly reliable electronic device package produced by the above method.

### BRIEF DESCRIPTION OF DRAWINGS

FIG 1 is a schematic vertical cross-sectional view illustrating an electronic device package according to one embodiment of the invention.
FIG. 2 is a schematic vertical cross-sectional view illustrating a method of producing an electronic device according to one embodiment of the invention (immobilizing resin layer-forming step to encapsulating material layer-forming step).
FIG 3 is a schematic vertical cross-sectional view illustrating a method of producing an electronic device according to one embodiment of the invention (encapsulating material-curing step and removal step).
FIG. 4 is a schematic vertical cross-sectional view illustrating a method of producing an electronic device according to one embodiment of the invention (encapsulating material-curing step and removal step).
FIG 5 is a schematic vertical cross-sectional view illustrating a method of producing an electronic device according to one embodiment of the invention (encapsulating material-curing/removal step).
FIG 6 is a schematic vertical cross-sectional view illustrating a method of producing an electronic device according to one embodiment of the invention (encapsulating material-curing/removal step).
FIG 7 is a schematic vertical cross-sectional view illustrating a method of producing an electronic device according to one embodiment of the invention (wiring layer-forming step).
FIG. 8 is a schematic vertical cross-sectional view illustrating a method of producing an electronic device according to one embodiment of the invention (wiring layer-forming step and dicing step).

### DESCRIPTION OF EMBODIMENTS

A methods of producing an electronic device, an electronic device, a method of producing an electronic device package, and an electronic device package according to preferred embodiments of the invention are described in detail below with reference to the drawings.

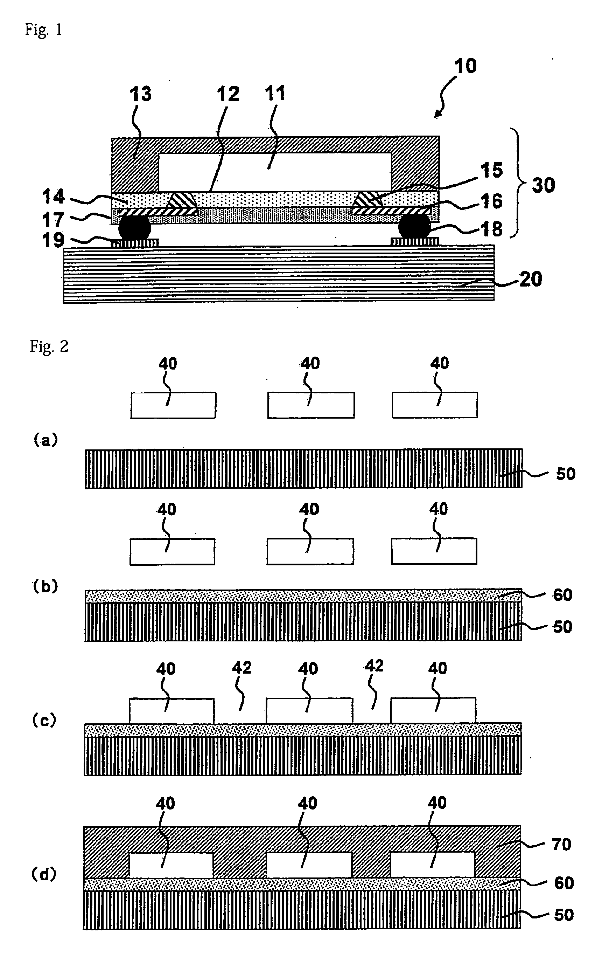

FIG 1 is a vertical cross-sectional view illustrating an example of an electronic device package that includes an electronic device produced by a method of producing an electronic device according to one embodiment of the invention. Note that the expressions "on" and "under" may respectively correspond to the upper side and the lower side in FIG. 1.

An electronic device package 10 illustrated in FIG 1 includes an interposer 20 on which a wiring circuit 19 is formed, and an electronic device 30 that is disposed on the interposer 20. The wiring circuit formed on the interposer 20 and the electronic device 30 are electrically connected via bumps 18.

The electronic device 30 includes a semiconductor chip 11, and a encapsulating section 13 that is provided to cover the semiconductor chip 11. Conductive via holes 15 that are connected to terminals (not illustrated in FIG 1) of the semiconductor chip 11, and a first insulating layer 14 that surrounds the conductive via holes 15 are provided under a functional surface 12 of the semiconductor chip 11. A conductor layer 16 that is connected to the conductive via holes 15 and a second insulating layer 17 are provided under the conductive via holes 15. The bumps 18 that are connected to the conductor layer 16 are provided under the conductor layer 16.

The interposer (substrate) 20 is a substrate that supports the electronic device 30. The interposer 20 normally has a quadrangular (e.g., square or rectangular) planar shape. The interposer 20 is formed of a resin material such as a polyimide resin, an epoxy resin, a cyanate resin, or a bismaleimide-triazine (BT) resin.

The wiring circuit 19 that is formed of a conductive metal material (e.g., copper) and has a given shape is provided on the upper side (one side) of the interposer 20.

The conductive via hole 15 electrically connects the terminal (not illustrated in FIG 1) of the semiconductor chip 11 and the conductor layer 16. A conductive layer may be formed only on the wall surface of the via hole 15, or may be formed in the entire via hole 15. When a conductive layer is formed only on the wall surface of the via hole 15, it is preferable that the via hole 15 be filled with an insulating material.

The conductor layer 16 electrically connects the conductive via hole 15 and the bump 18. The conductor layer 16 is formed of a conductive metal material (e.g., copper).

The bump 18 electrically connects the conductor layer 16 and the wiring circuit 19 formed on the interposer 20. The bump 18 protrudes from the electronic device 30 almost in the shape of a ball. The bump 18 is mainly formed of a filler metal (e.g., solder, silver solder, copper filler metal, or copper phosphorus filler metal).

The electronic device 30 illustrated in FIG 1 is produced by a method of producing an electronic device according to one embodiment of the invention, for example.

### Method of producing electronic device

A method of producing an electronic device according to a first embodiment of the invention (hereinafter may be referred to as "method (1)") includes:
an immobilizing resin layer-forming step that includes forming an immobilizing resin layer on a surface of a support substrate;
an electronic part-immobilizing step that includes disposing a plurality of electronic parts on the immobilizing resin layer so that a space is formed between adjacent electronic parts among the plurality of electronic parts to immobilize the plurality of electronic parts on the support substrate via the immobilizing resin layer;
a encapsulating material layer-forming step that includes covering the plurality of electronic parts with a encapsulating material to form a encapsulating material layer on the immobilizing resin layer and the plurality of electronic parts;
a encapsulating material-curing step that includes curing the encapsulating material by heating the encapsulating material to obtain a encapsulating material cured product which is supported on the support substrate and in which the plurality of electronic parts are disposed; and
a removal step that includes removing the encapsulating material cured product supported on the support substrate from the support substrate,
the removal step removing the encapsulating material cured product from the support substrate by reducing a molecular weight of a resin included in the immobilizing resin layer.

A method of producing an electronic device according to a second embodiment of the invention (hereinafter may be referred to as "method (2)") includes: an immobilizing resin layer-forming step that includes forming an immobilizing resin layer on a surface of a support substrate; an electronic part-immobilizing step that includes disposing a plurality of electronic parts on the immobilizing resin layer so that a space is formed between adjacent electronic parts among the plurality of electronic parts to immobilize the plurality of electronic parts on the support substrate via the immobilizing resin layer; a encapsulating material layer-forming step that includes covering the plurality of electronic parts with a encapsulating material to form a encapsulating material layer on the immobilizing resin layer and the plurality of electronic parts; and a encapsulating material-curing/removal step that includes curing the encapsulating material by heating the encapsulating material to obtain a encapsulating material cured product which is supported on the support substrate and in which the plurality of electronic parts are disposed, and removing the encapsulating material cured product from the support substrate, the encapsulating material-curing/removal step removing the encapsulating material cured product from the support substrate by reducing a molecular weight of a resin included in the immobilizing resin layer.

Specifically, the method (1) and the method (2) differ in that the method (1) performs the removal step after performing the encapsulating material-curing step, while the method (2) performs the encapsulating material-curing/removal step that cures and removes the encapsulating material.

In the method (1), the encapsulating material cured product is removed from the support substrate in the removal step by reducing the molecular weight of the resin included in the immobilizing resin layer. In the method (2), the encapsulating material cured product is removed from the support substrate in the encapsulating material-curing/removal step by reducing the molecular weight of the resin included in the immobilizing resin layer.

In the removal step of the method (1) and the encapsulating material-curing/removal step of the method (2), the molecular weight of the resin included in the immobilizing resin layer may be reduced by an arbitrary method. For example, the following methods may be employed.

According to a first embodiment of the method (1) (hereinafter referred to as "method (1A)"), a thermally decomposable immobilizing resin layer (hereinafter may be referred to as "immobilizing resin layer (A)") is used as the immobilizing resin layer, and the removal step includes thermally decomposing a thermally decomposable resin included in the immobilizing resin layer by heating the immobilizing resin layer at a temperature equal to or higher than the thermal decomposition temperature of the thermally decomposable resin to reduce the molecular weight of the thermally decomposable resin included in the immobilizing resin layer, and volatilizing the thermally decomposable resin to remove the encapsulating material cured product from the support substrate. Specifically, the immobilizing resin layer is thermally decomposed by heating the immobilizing resin layer without applying active energy rays to the immobilizing resin layer. According to a first embodiment of the method (2) (hereinafter referred to as "method (2A)"), a thermally decomposable immobilizing resin layer (immobilizing resin layer (A)) is used as the immobilizing resin layer, and the encapsulating material-curing/removal step includes heating the immobilizing resin layer at a temperature equal to or higher than the thermal decomposition temperature of a thermally decomposable resin included in the immobilizing resin layer to reduce the molecular weight of the thermally decomposable resin included in the immobilizing resin layer, and volatilizing the thermally decomposable resin to remove the encapsulating material cured product from the support substrate. Specifically, the immobilizing resin layer is thermally decomposed by heating the immobilizing resin layer without applying active energy rays to the immobilizing resin layer.

The immobilizing resin layer (A) is thermally decomposed (i.e., the thermally decomposable resin included in the immobilizing resin layer is thermally decomposed) by heating the immobilizing resin layer at a temperature equal to or higher than the thermal decomposition temperature of the thermally decomposable resin, so that the encapsulating material cured product can be removed from the support substrate.

Note that the thermal decomposition temperature of the immobilizing resin layer refers to the 5% weight loss temperature of the thermally decomposable resin included in the immobilizing resin layer.

According to a second embodiment of the method (1) (hereinafter referred to as "method (1B)"), a thermally decomposable immobilizing resin layer that decreases in thermal decomposition temperature upon application of active energy rays (hereinafter may be referred to as "immobilizing resin layer (B)") is used as the immobilizing resin layer, and the removal step includes applying active energy rays to the immobilizing resin layer (B), and thermally decomposing the immobilizing resin layer (B) by heating the immobilizing resin layer (B) at a temperature equal to or higher than the thermal decomposition temperature of the immobilizing resin layer (B) to which the active energy rays have been applied, to remove the encapsulating material cured product from the support substrate. According to a second embodiment of the method (2) (hereinafter referred to as "method (2B)"), a thermally decomposable immobilizing resin layer that decreases in thermal decomposition temperature upon application of active energy rays (immobilizing resin layer (B)) is used as the immobilizing resin layer, and the encapsulating material-curing/removal step includes applying active energy rays to the immobilizing resin layer (B), and thermally decomposing the immobilizing resin layer (B) by heating the immobilizing resin layer (B) at a temperature equal to or higher than the thermal decomposition temperature of the immobilizing resin layer (B) to which the active energy rays have been applied, to remove the encapsulating material cured product from the support substrate. According to the methods (1B) and (2B), the immobilizing resin layer (B) includes a photoacid generator that generates an acid upon application of active energy rays or a photobase generator that generates a base upon application of active energy rays, and a thermally decomposable resin that decreases in molecular weight and thermal decomposition temperature when heated in the presence of an acid or a base. Active energy rays are applied to the immobilizing resin layer (B) to generate an acid or a base in the immobilizing resin layer (B), and the immobilizing resin layer (B) is heated in the presence of an acid or a base to reduce the molecular weight of the thermally decomposable resin included in the immobilizing resin layer (B). The thermally decomposable resin that has decreased in molecular weight is thermally decomposed or volatilized to remove the encapsulating material cured product from the support substrate.

The immobilizing resin layer (B) is thermally decomposed by heating the immobilizing resin layer (B) at a temperature equal to or higher than the thermal decomposition temperature of the immobilizing resin layer (B), so that the encapsulating material cured product can be removed from the support substrate. Specifically, an acid or a base is generated in the immobilizing resin layer (B) by applying active energy rays to the immobilizing resin layer (B), and the molecular weight of the thermally decomposable resin included in the immobilizing resin layer (B) is reduced by heating the immobilizing resin layer (B) in the presence of an acid or a base. The thermally decomposable resin that has decreased in molecular weight is thermally decomposed or volatilized to remove the encapsulating material cured product from the support substrate.

According to a third embodiment of the method (1) (hereinafter referred to as "method (1C)"), a hot-melt immobilizing resin layer that decreases in melting temperature upon application of active energy rays (hereinafter may be referred to as "immobilizing resin layer (C)") is used as the immobilizing resin layer, and the removal step includes applying active energy rays to the immobilizing resin layer (C), and melting the immobilizing resin layer (C) by heating the immobilizing resin layer (C) at a temperature equal to or higher than the melting temperature of the immobilizing resin layer (C) to which the active energy rays have been applied, to remove the encapsulating material cured product from the support substrate. According to a third embodiment of the method (2) (hereinafter referred to as "method (2C)"), a hot-melt immobilizing resin layer that decreases in melting temperature upon application of active energy rays (immobilizing resin layer (C)) is used as the immobilizing resin layer, and the encapsulating material-curing/removal step includes applying active energy rays to the immobilizing resin layer (C), and melting the (immobilizing resin layer (C) by heating the immobilizing resin layer (C) at a temperature equal to or higher than the melting temperature of the immobilizing resin layer (C) to which the active energy rays have been applied, to remove the encapsulating material cured product from the support substrate. According to the methods (1C) and (2C), the immobilizing resin layer (C) includes a photoacid generator that generates an acid upon application of active energy rays or a photobase generator that generates a base upon application of active energy rays, and a hot-melt resin that decreases in molecular weight and melting temperature when heated in the presence of an acid or a base. Active energy rays are applied to the immobilizing resin layer (C) to generate an acid or a base in the immobilizing resin layer (C), and the immobilizing resin layer (C) is heated in the presence of an acid or a base to reduce the molecular weight and the melting temperature of the hot-melt resin included in the immobilizing resin layer (C). The encapsulating material cured product is thus removed from the support substrate.

The immobilizing resin layer (C) is melted by heating the immobilizing resin layer (C) at a temperature equal to or higher than the melting temperature of the immobilizing resin layer (C), so that the encapsulating material cured product can be removed from the support substrate. Specifically, an acid or a base is generated in the immobilizing resin layer (C) by applying active energy rays to the immobilizing resin layer (C), and the molecular weight and the melting temperature of the hot-melt resin included in the immobilizing resin layer (C) are reduced by heating the immobilizing resin layer (C) in the presence of an acid or a base, so that the encapsulating material cured product can be removed from the support substrate.

Note that the melting temperature of the immobilizing resin layer refers to a temperature at which the melt viscosity of the hot-melt resin included in the immobilizing resin layer becomes equal to or less than 100 Pa·s.

According to the methods (1B), (1C), (2B), and (2C), since the thermal decomposition temperature or the melting temperature can be reduced by applying active energy rays when removing the encapsulating material cured product from the support substrate in the removal step or the encapsulating material-curing/removal step, the encapsulating material cured product can be removed from the support substrate by heating the immobilizing resin layer at a low temperature. This makes it possible to reduce damage to the encapsulating material cured product while preventing breakage (e.g., cracks) of the electronic parts and the encapsulating material.

The methods (1) and (2) are described in detail below with reference to FIGS. 2 to 8. FIGS. 2 to 8 are vertical cross-sectional views illustrating a method of producing a redistribution-type electronic device 30 wherein a wire is provided outside the outer edge of each electronic part 40 when viewed from above. Note that the expressions "on" and "under" may respectively correspond to the upper side and the lower side in FIGS. 2 to 8. Note that the method (1) and the method (2) differ in that the method (1) performs the removal step after performing the encapsulating material-curing step, while the method (2) performs the encapsulating material-curing/removal step that cures and removes the encapsulating material. The method (1) and the method (2) are identical as to the remaining steps.

### [1] As illustrated in FIG. 2(a), electronic parts 40, and a support substrate 50 having flatness, rigidity, and heat resistance are provided.

Examples of the electronic parts 40 include, but are not limited to, active devices such as a semiconductor chip, passive devices such as a capacitor and a filter, and the like.

The support substrate 50 is not particularly limited as long as the support substrate 50 has flatness, rigidity, and heat resistance. Examples of the support substrate 50 include a silicon wafer, a ceramic sheet, a metal sheet (e.g., stainless steel sheet and copper sheet), and the like. Among these, a silicon wafer is preferable from the viewpoint of workability in the encapsulating material layer-forming step and a wiring layer-forming step, and availability of existing equipment. When applying active energy rays in the removal step or the encapsulating material-curing/removal step, the support substrate is formed of a material that ensures flatness, rigidity, and heat resistance, and allows active energy rays to pass through. Examples of such a material include a glass material (e.g., quartz glass and soda glass) and a resin material (e.g., polyethylene terephthalate, polyethylene naphthalate, polypropylene, cycloolefin polymer, polyamide, and polycarbonate).

### [2] An immobilizing resin layer 60 for immobilizing the electronic parts 40 on the support substrate 50 is formed (FIG. 2(b), immobilizing resin layer-forming step).

It is preferable to form the immobilizing resin layer 60 to have a uniform thickness so that wires can be accurately formed in the wiring layer-forming step. The immobilizing resin layer 60 may be formed by an arbitrary method. For example, the immobilizing resin layer 60 may be formed by applying a liquid immobilizing resin composition using a spin coating method, a printing method, or a dispensing method, or laminating a film-shaped immobilizing resin composition. It is preferable to form immobilizing resin layer 60 by applying a liquid immobilizing resin composition using a spin coating method, or laminating a film-shaped immobilizing resin composition since the resulting immobilizing resin layer 60 has a uniform thickness.

When forming the immobilizing resin layer 60 by applying a liquid immobilizing resin composition using a spin coating method, a printing method, or a dispensing method, a varnish-like immobilizing resin composition prepared by dissolving an immobilizing resin composition that is liquid at room temperature or an immobilizing resin composition that is solid at room temperature in a solvent or a diluent may be applied using a spin coater, a printer, or a dispenser to form the immobilizing resin layer 60, for example.

When forming the immobilizing resin layer 60 by laminating a film-shaped immobilizing resin composition, a varnish-like immobilizing resin composition may be applied to a base film (e.g., polyethylene, polypropylene, or polyethylene terephthalate), and dried to form a film-shaped immobilizing resin composition, and the film-shaped immobilizing resin composition may be laminated using a laminator or the like, for example.

The details of the immobilizing resin layer 60 used in the methods (1A), (1B), (1C), (2A), (2B), and (2C) are described below. Note that the immobilizing resin layer is appropriately selected depending on the method that reduces the molecular weight of the resin included in the immobilizing resin layer.

The immobilizing resin layer 60 used in the method (1A) is the thermally decomposable immobilizing resin layer (A) that includes a thermally decomposable resin that is thermally decomposed by heating the immobilizing resin layer (A) at a temperature equal to or higher than the thermal decomposition temperature of the thermally decomposable resin. The 5% weight loss temperature of the thermally decomposable resin included in the immobilizing resin layer (A) is preferably 400°C or less, and particularly preferably 350°C or less. When the 5% weight loss temperature of the thermally decomposable resin included in the immobilizing resin layer (A) is within the above range, the electronic parts 40 and a encapsulating material cured product layer 71 are affected by heat to only a small extent when thermally decomposing the immobilizing resin layer 60. Specifically, the immobilizing resin layer (A) can be thermally decomposed at a temperature equal to or less than 400°C by utilizing the immobilizing resin layer (A) that includes a thermally decomposable resin having a 5% weight loss temperature within the above range, and adjusting the heating time. Therefore, the electronic parts 40 and the encapsulating material cured product layer 71 are affected by heat to only a small extent when thermally decomposing the immobilizing resin layer (A).

Note that a linear or branched thermally decomposable resin that does not have an alicyclic skeleton and an aromatic skeleton may be selected when it is desired that the 5% weight loss temperature of the thermally decomposable resin included in the immobilizing resin layer (A) be within the above range, for example.

The weight loss of the thermally decomposable resin included in the immobilizing resin layer (A) when heating the immobilizing resin layer (A) at the heating temperature is preferably 1% or more, and particularly preferably 5% or more. When the weight loss of the thermally decomposable resin included in the immobilizing resin layer (A) when heating the immobilizing resin layer (A) at the heating temperature is within the above range, the amount of residue of the immobilizing resin layer (A) that adheres to the encapsulating material cured product can be reduced. Specifically, the immobilizing resin layer (A) can be thermally decomposed by utilizing the immobilizing resin layer (A) that includes a thermally decomposable resin having a weight loss within the above range when heating the immobilizing resin layer (A) at the heating temperature, and adjusting the heating time.

Note that the weight loss of thermally decomposable resin at the heating temperature employed when heating the immobilizing resin layer refers to a value measured by thermogravimetric/differential thermal analysis (TG/DTA) (atmosphere: nitrogen, the temperature is increased at 10°C/min until the heating temperature of the immobilizing resin layer is reached, and maintained constant after the heating temperature of the immobilizing resin layer has been reached). Specifically, about 10 mg of the resin is weighed precisely, and subjected to TG/DTA (atmosphere: nitrogen, the temperature is increased at 10°C/min until the heating temperature of the immobilizing resin layer is reached, and maintained constant after the heating temperature of the immobilizing resin layer has been reached) using a TG/DTA system (manufactured by Seiko Instruments Inc.).

The 5% weight loss temperature of the thermally decomposable resin included in the immobilizing resin layer (A) is preferably 50°C or more, and particularly preferably 100°C or more. When the 5% weight loss temperature of the thermally decomposable resin included in the immobilizing resin layer (A) is within the above range, it is possible to prevent a situation in which the immobilizing resin layer (A) is unnecessarily thermally decomposed when forming and curing a encapsulating material layer 70.

Note that the molecular weight of the resin may be adjusted when it is desired that the 5% weight loss temperature of the thermally decomposable resin included in the immobilizing resin layer (A) be 50°C or more.

Note that the 5% weight loss temperature of the thermally decomposable resin refers to a temperature at which 5% of the weight of the thermally decomposable resin is lost when measured by TG/DTA. Specifically, about 10 mg of the resin is weighed precisely, and subjected to TG/DTA (atmosphere: nitrogen, temperature increase rate: 5°C/min) using a TG/DTA system (manufactured by Seiko Instruments Inc.).

Examples of the thermally decomposable resin included in the immobilizing resin layer (A) include a polycarbonate resin, a polyester resin, a polyamide resin, a polyimide resin, a polyether resin, a polyurethane resin, and the like. Among these, a polycarbonate resin is preferable since the thermal decomposition time of the immobilizing resin layer (A) can be effectively reduced. Note that the immobilizing resin layer (A) may include only one type of thermally decomposable resin, or may include two or more types of thermally decomposable resin.

The term "polycarbonate resin" used herein refers to a resin in which at least the main chain includes a carbonate group (-O-(C=O)-O-) as a structural unit. The polycarbonate resin may include another structural unit.

The term "polyester resin" used herein refers to a resin in which at least the main chain includes an ester group (-(C=O)-O-) as a structural unit. The polyester resin may include another structural unit.

The term "polyamide resin" used herein refers to a resin in which at least the main chain includes an amide bond (-NH-(C=O)-) as a structural unit. The polyamide resin may include another structural unit.

The term "polyimide resin" used herein refers to a resin in which at least the main chain includes an imide bond (-(C=O)-NR-(C=O)-) as a structural unit. The polyimide resin may include another structural unit. Note that R represents an organic group.

The term "polyether resin" used herein refers to a resin in which at least the main chain includes an ether group (-O-) as a structural unit. The polyether resin may include another structural unit.

The term "polyurethane resin" used herein refers to a resin in which at least the main chain includes a urethane bond (-O-(C=O)-NH-) as a structural unit. The polyurethane resin may include another structural unit.

The polycarbonate resin (thermally decomposable resin) that may be included in the immobilizing resin layer (A) is not particularly limited. Examples of the polycarbonate resin include a polypropylene carbonate resin, a polyethylene carbonate resin, a 1,2-polybutylene carbonate resin, a 1,3-polybutylene carbonate resin, a 1,4-polybutylene carbonate resin, a cis-2,3-polybutylene carbonate resin, a trans-2,3-polybutylene carbonate resin, an α,β-polyisobutylene carbonate resin, an α,γ-polyisobutylene carbonate resin, a cis-1,2-polycyclobutylene carbonate resin, a trans-1,2-polycyclobutylene carbonate resin, a cis-1,3-polycyclobutylene carbonate resin, a trans-1,3-polycyclobutylene carbonate resin, a polyhexene carbonate resin, a polycyclopropene carbonate resin, a polycyclohexene carbonate resin, a 1,3-polycyclohexane carbonate resin, a poly(methylcyclohexene carbonate) resin, a poly(vinylcyclohexene carbonate) resin, a polydihydronaphthalene carbonate resin, a polyhexahydrostyrene carbonate resin, a polycyclohexanepropylene carbonate resin, a polystyrene carbonate resin, a poly(3-phenylpropylene carbonate) resin, a poly(3-trimethylsilyloxypropylene carbonate) resin, a poly(3-methacryloyloxypropylene carbonate) resin, a polyperfluoropropylene carbonate resin, a polynorbornene carbonate resin, a polynorbornane carbonate resin, and combinations thereof.

Further examples of the polycarbonate resin (thermally decomposable resin) that may be included in the immobilizing resin layer (A) include a polypropylene carbonate/polycyclohexene carbonate copolymer, a 1,3-polycyclohexane carbonate/polynorbornene carbonate copolymer,
a poly[(oxycarbonyloxy-1,1,4,4-tetramethylbutane)-alt-(oxycarbonyloxy-5-norbomene-2-endo-3 -endo-dimethane)] resin,
a poly[(oxycarbonyloxy-1,4-dimethylbutane)-alt-(oxycarbonyloxy-5-norbornene-2-endo-3-endo-dimetan)] resin,
a poly[(oxycarbonyloxy-1,1,4,4-tetramethylbutane)-alt-(oxycarbonyloxy-p-xylene)] resin, poly[(oxycarbonyloxy-1,4-dimethylbutane)-alt-(oxycarbonyloxy-p-xylene)] resin, and the like.

The weight average molecular weight (Mw) of the polycarbonate resin (thermally decomposable resin) that may be included in the immobilizing resin layer (A) is preferably 1000 to 1,000,000, and particularly preferably 5000 to 800,000. When the weight average molecular weight (Mw) of the polycarbonate resin (thermally decomposable resin) that may be included in the immobilizing resin layer (A) is 1000 or more, it is possible to improve wettability with the electronic parts 40 and the support substrate 50, and improve the film-forming capability. When the weight average molecular weight (Mw) of the polycarbonate resin (thermally decomposable resin) that may be included in the immobilizing resin layer (A) is 1,000,000 or less, it is possible to improve solubility in various solvents, and improve the thermal decomposition properties of the immobilizing resin layer 60.

The polycarbonate resin (thermally decomposable resin) that may be included in the immobilizing resin layer (A) may be polymerized by an arbitrary method. For example, the polycarbonate resin may be polymerized by a phosgene method (solution method), a transesterification method (melting method), or the like.

The content of the thermally decomposable resin in the immobilizing resin layer (A) is preferably 30 to 100 wt%, more preferably 50 to 100 wt%, and particularly preferably 60 to 140 wt%. When the content of the thermally decomposable resin in the immobilizing resin layer (A) is within the above range, it is possible to reduce the amount of residue after thermally decomposing the immobilizing resin layer (A).

It is particularly preferable to use polypropylene carbonate, 1,4-polybutylene carbonate, or a 1,3-polycyclohexane carbonate/polynorbornene carbonate copolymer as the thermally decomposable resin included in the immobilizing resin layer (A) since these thermally decomposable resins are rarely thermally decomposed at the temperature at which the encapsulating material layer 70 is thermally cured, and exhibit excellent thermal decomposition properties at a temperature equal to or higher than the temperature at which the encapsulating material layer 70 is thermally cured.

The immobilizing resin layer 60 used in the method (1B) is the immobilizing resin layer (B) that decreases in thermal decomposition temperature upon application of active energy rays. Examples of the immobilizing resin layer (B) include an immobilizing resin layer that includes a thermally decomposable resin that decreases in thermal decomposition temperature when heated in the presence of an acid or a base, and a photoacid generator that generates an acid upon application of active energy rays or a photobase generator that generates a base upon application of active energy rays.

When the immobilizing resin layer (B) includes a thermally decomposable resin that decreases in thermal decomposition temperature when heated in the presence of an acid or a base, and a photoacid generator that generates an acid upon application of active energy rays or a photobase generator that generates a base upon application of active energy rays, an acid or a base is generated in the immobilizing resin layer (B) when active energy rays are applied to the immobilizing resin layer (B), and the molecular chains of the thermally decomposable resin are cut when the thermally decomposable resin is heated in the presence of the acid or base, so that the molecular weight of the thermally decomposable resin decreases. Therefore, the thermal decomposition temperature of the immobilizing resin layer (B) decreases by applying active energy rays to the immobilizing resin layer (B).

Examples of the thermally decomposable resin that decreases in thermal decomposition temperature when heated in the presence of an acid or a base include the polycarbonate resin, the polyester resin, the polyamide resin, the polyimide resin, the polyether resin, the polyurethane resin, and the like mentioned above in connection with the immobilizing resin layer (A).

When using the immobilizing resin layer (B) as the immobilizing resin layer 60, since the thermal decomposition temperature of the immobilizing resin layer (B) can be reduced by applying active energy rays to the immobilizing resin layer (B), it is preferable to form the immobilizing resin layer (B) on the support substrate 50, and then reduce the thermal decomposition temperature of the immobilizing resin layer (B) by applying active energy rays since it is possible to prevent a situation in which the electronic device is thermally damaged.

A mechanism by which the thermal decomposition temperature of the thermally decomposable resin decreases is described below taking an example in which the immobilizing resin layer (B) includes a polypropylene carbonate resin (i.e., polycarbonate resin) as the thermally decomposable resin that decreases in thermal decomposition temperature when heated in the presence of an acid or a base. As shown by the following formula (1), H⁺ derived from the photoacid generator protonates the carbonyl oxygen of the polypropylene carbonate resin, and causes a change in polar transition state to obtain unstable tautomeric intermediates [A] and [B]. The intermediate [A] decreases in molecular weight and thermal decomposition temperature due to thermal cleavage into acetone and CO₂. The intermediate [B] decreases in molecular weight and thermal decomposition temperature due to formation of a thermally cyclized structure that produces propylene carbonate which is fragmented into CO₂ and propylene oxide.

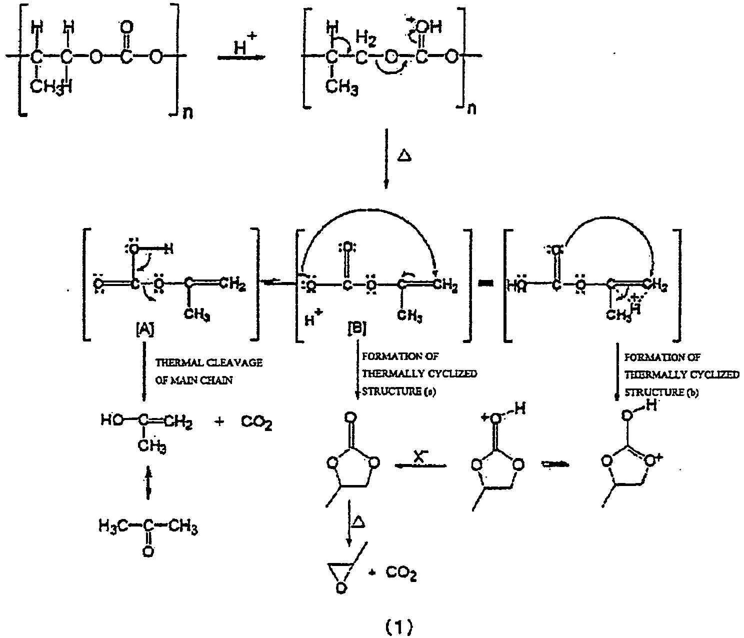

The photoacid generator is not particularly limited as long as the photoacid generator is a compound that generates an acid upon application of active energy rays. Examples of the photoacid generator include nucleophilic halides, complex metal halide anions, and the like. Specific examples of the photoacid generator include 4-methylphenyl[4-(1-methylethyl)phenyl]iodonium tetrakis(pentafluorophenyl)borate (DPI-TPFPB), tris(4-t-butylphenyl)sulfonium tetrakis(pentafluorophenyl)borate (TTBPS-TPFPB), tris(4-t-butylphenyl)sulfonium hexafluorophosphate (TTBPS-HFP), triphenylsulfonium trifluoromethanesulfonate (TPS-Tf), bis(4-tert-butylphenyl)iodonium trifluoromethanesulfonate (DTBPI-Tf), triazine (TAZ-101), triphenylsulfonium hexafluoroantimonate (TPS-103), triphenylsulfonium bis(perfluoromethanesulfonyl)imide (TPS-N1), di(p-t-butyl)phenyliodonium, bis(perfluoromethanesulfonyl)imide (DTBPI-N1), triphenylsulfonium tris(perfluoromethanesulfonyl)methide (TPS-C1), di(p-t-butylphenyl)iodonium tris(perfluoromethanesulfonyl)methide (DTBPI-C1), and the like. These photoacid generators may be used either alone or in combination.

The photobase generator is not particularly limited. Examples of the photobase generator include 5-benzyl-1,5-diazabicyclo(4.3.0)nonane, 1-(2-nitrobenzoylcarbamoyl)imidazole, and the like. These photobase generators may be used either alone or in combination. It is preferable to use 5-benzyl-1,5-diazabicyclo(4.3.0)nonane or a derivative thereof as the photobase generator since the thermal decomposition temperature or the melting temperature of the resin can be efficiently reduced.

The content of the photoacid generator or the photobase generator in the immobilizing resin layer (B) is preferably 0.1 to 15 parts by weight, and particularly preferably 0.5 to 10 parts by weight, based on 100 parts by weight of the thermally decomposable resin that decreases in thermal decomposition temperature when heated in the presence of an acid or a base. When the content of the photoacid generator or the photobase generator in the immobilizing resin layer (B) is within the above range, the thermal decomposition temperature can be effectively reduced by applying active energy rays. Moreover, the amount of residue after thermal decomposition can be reduced.

It is preferable that the thermal decomposition temperature of the immobilizing resin layer (B) after applying active energy rays to the immobilizing resin layer (B) (i.e., the 5% weight loss temperature of the thermally decomposable resin included in the immobilizing resin layer (B) that decreases in thermal decomposition temperature when heated in the presence of an acid or a base) be 100 to 200°C, and particularly preferably 120 to 100°C.

The immobilizing resin layer (B) may include a sensitizer (i.e., a component that ensures or enhances the reactivity of the photoacid generator or the photobase generator with a specific type of light or light having a specific wavelength) in addition to the photoacid generator or the photobase generator.

The sensitizer that may be included in the immobilizing resin layer (B) is not particularly limited. Examples of the sensitizer that may be included in the immobilizing resin layer (B) include anthracene, phenanthrene, chrysene, benzpyrene, fluoranthene, rubrene, pyrene, xanthone, indanthrene, thioxanthen-9-one, 2-isopropyl-9H-thioxanthen-9-one, 4-isopropyl-9H-thioxanthen-9-one, 1-chloro-4-propoxythioxanethone, mixtures thereof, and the like. The content of the sensitizer in the immobilizing resin layer (B) is preferably 100 parts by mass or less, and particularly preferably 50 parts by mass or less, based on 100 parts by mass of the photoacid generator or the photobase generator.

The immobilizing resin layer 60 used in the method (1C) is the immobilizing resin layer (C) that decreases in melting temperature upon application of active energy rays. Examples of the immobilizing resin layer (C) include an immobilizing resin layer that includes a hot-melt resin that decreases in melting temperature when heated in the presence of an acid or a base, and a photoacid generator that generates an acid upon application of active energy rays or a photobase generator that generates a base upon application of active energy rays.

When the immobilizing resin layer (C) includes a hot-melt resin that decreases in melting temperature when heated in the presence of an acid or a base, and a photoacid generator that generates an acid upon application of active energy rays or a photobase generator that generates a base upon application of active energy rays, an acid or a base is generated in the immobilizing resin layer (C) when active energy rays are applied to the immobilizing resin layer (C), and the molecular chains of the thermally decomposable resin are cut when the thermally decomposable resin is heated in the presence of the acid or base, so that the molecular weight of the thermally decomposable resin decreases. As a result, the melting temperature of the hot-melt resin included in the immobilizing resin layer (C) decreases. Therefore, the melting temperature of the immobilizing resin layer (C) decreases by applying active energy rays to the immobilizing resin layer (C).

Examples of the hot-melt resin that is included in the immobilizing resin layer (C) and decreases in melting temperature when heated in the presence of an acid or a base include a polycarbonate resin, a polyester resin, a polyamide resin, a polyether resin, a polyurethane resin, a vinyl resin, a (meth)acrylate resin, and the like. Among these, a polycarbonate resin, a vinyl resin, and a (meth)acrylate resin are preferable, and a polycarbonate resin is particularly preferable since a significant decrease in melting temperature is obtained in the presence of an acid or a base.

Examples of the vinyl resin (hot-melt resin) that may be included in the immobilizing resin layer (C) and decreases in melting temperature when heated in the presence of an acid or a base include, but are not limited to, polystyrene, styrene derivatives such as poly-α-methylstyrene, polyvinyl ethers such as poly(ethyl vinyl ether), poly(butyl vinyl ether), and polyvinyl formal, derivatives thereof, and the like. These resins may be used either alone or in combination. Among these, poly-α-methylstyrene is preferable from the point of workability.

Examples of the (meth)acrylate resin that may be included in the immobilizing resin layer (C) and decreases in melting temperature when heated in the presence of an acid or a base include, but are not limited to, methyl (meth)acrylate, ethyl (meth)acrylate, n-propyl (meth)acrylate, n-butyl (meth)acrylate, (meth)acrylic acid, 2-hydroxyethyl (meth)acrylate, copolymers thereof, and the like. Among these, poly(methyl methacrylate) and poly(ethyl methacrylate) are preferable from the point of workability.

Examples of the polycarbonate resin that may be included in the immobilizing resin layer (C) and decreases in melting temperature when heated in the presence of an acid or a base include, but are not limited to, a polycarbonate resin that includes a carbonate structural unit including a linear chemical structure (e.g., polypropylene carbonate, polyethylene carbonate, and polybutylene carbonate), and a polycarbonate resin that includes a carbonate structural unit including a cyclic chemical structure. Among these, a polycarbonate resin that includes a carbonate structural unit including a cyclic chemical structure is preferable from the viewpoint of workability. The polycarbonate resin that includes a carbonate structural unit including a cyclic chemical structure is described in detail below.

The polycarbonate resin that includes a carbonate structural unit including a cyclic chemical structure is not particularly limited as long as the carbonate structural unit includes a cyclic chemical structure (hereinafter may be referred to as "ring"). It is preferable to use a polycarbonate resin that includes a carbonate structural unit including at least two rings. The melt viscosity at 180°C of the polycarbonate resin that includes a carbonate structural unit including a cyclic chemical structure can be set within the range mentioned below due to an acid or a base generated by the photoacid generator or the photobase generator upon application of active energy rays by appropriately selecting the number or the type of rings.

It is preferable that the polycarbonate resin that includes a carbonate structural unit including a cyclic chemical structure have two to five, more preferably two or three, and particularly preferably two rings per carbonate structural unit. When the number of rings per carbonate structural unit is within the above range, the immobilizing resin layer (C) exhibits excellent adhesion to the support substrate 50 before applying active energy rays.

When the polycarbonate resin that includes a carbonate structural unit including a cyclic chemical structure has two or more rings per carbonate structural unit, the rings may form a polycyclic structure in which vertices of the rings are bonded. It is preferable that the rings form a fused polycyclic structures in which sides of the rings are bonded. In this case, since the planarity of the carbonate structural unit is improved, it is possible to increase the difference between the melting temperature before applying active energy rays and the melting temperature after applying active energy rays.

It is preferable that the rings included in the polycarbonate resin that includes a carbonate structural unit including a cyclic chemical structure be a 5-membered ring or a 6-membered ring. In this case, since the planarity of the carbonate structural unit is maintained, it is possible to increase the difference between the melting temperature before applying active energy rays and the melting temperature after applying active energy rays. It is also possible to stabilize solubility in a solvent.

It is preferable that the rings included in the polycarbonate resin that includes a carbonate structural unit including a cyclic chemical structure have an alicyclic structure. The above effects are more significantly achieved when each ring has an alicyclic structure.

It is particularly preferable that the polycarbonate resin that includes a carbonate structural unit including a cyclic chemical structure include a carbonate structural unit shown by the following chemical formula (2), for example.

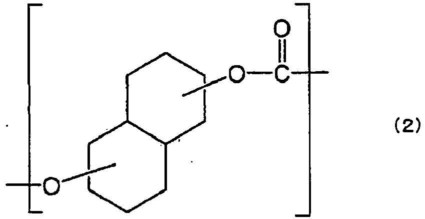

Note that a polycarbonate resin that includes the carbonate structural unit shown by the chemical formula (2) is obtained by a polycondensation reaction between decalindiol and a diester carbonate such as diphenyl carbonate.

In the carbonate structural unit shown by the chemical formula (2), it is preferable that the two oxygen atoms derived from the two hydroxyl groups of decalindiol be bonded directly to carbon atoms that form decalin (i.e., two rings that form the fused polycyclic structure), and three or more atoms be present between the carbon atoms to which the two oxygen atoms are respectively bonded. In this case, since the linearity of the polycarbonate resin is maintained, it is possible to reliably increase the difference between the melting temperature before applying active energy rays and the melting temperature after applying active energy rays. It is also possible to stabilize solubility in a solvent.

Examples of such a carbonate structural unit include the carbonate structural units shown by the following chemical formulas (2A) and (2B).

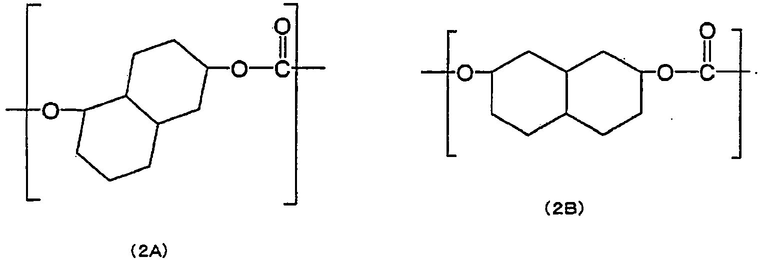

The rings included in the polycarbonate resin that includes a carbonate structural unit including a cyclic chemical structure may have a heteroalicyclic structure. The above effects are also more significantly achieved when each ring has a heteroalicyclic structure.

In this case, it is particularly preferable that the polycarbonate resin that includes a carbonate structural unit including a cyclic chemical structure include a carbonate structural unit shown by the following chemical formula (3X), for example.

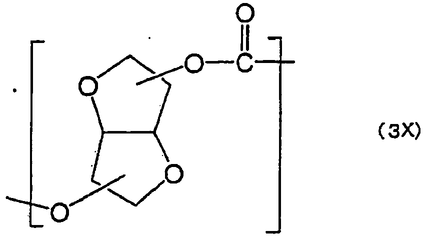

Note that a polycarbonate resin that includes the carbonate structural unit shown by the chemical formula (3X) is obtained by a polycondensation reaction between a cyclic ether diol shown by the following chemical formula (3a) and a diester carbonate such as diphenyl carbonate.

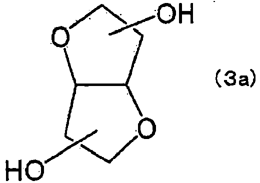

In the carbonate structural unit shown by the chemical formula (3X), it is preferable that the two oxygen atoms derived from the two hydroxyl groups of the cyclic ether diol shown by the chemical formula (3a) be bonded directly to carbon atoms that form the cyclic ether (i.e., two rings that form the fused polycyclic structure), and three or more atoms be present between the carbon atoms to which the two oxygen atoms are respectively bonded. In this case, since the decomposition properties of the polycarbonate can be controlled, it is possible to more reliably increase the difference between the melting temperature before applying active energy rays and the melting temperature after applying active energy rays. It is also possible to stabilize solubility in a solvent.

Examples of such a carbonate structural unit include the 1,4:3,6-dianhydro-D-sorbitol (isosorbide) structural unit shown by the following chemical formula (3A), and the 1,4:3,6-dianhydro-D-mannitol (isomannide) structural unit shown by the following chemical formula (3B).

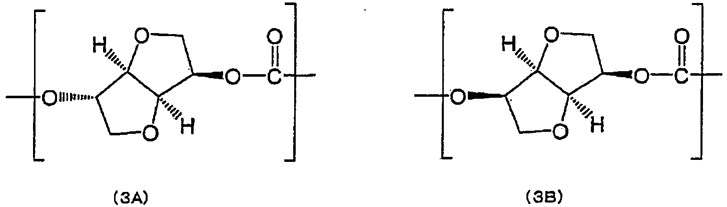

The weight average molecular weight (Mw) of the hot-melt resin that is included in the immobilizing resin layer (C) and decreases in melting temperature when heated in the presence of an acid or a base is preferably 1000 to 1,000,000, and particularly preferably 5000 to 800,000. When the weight average molecular weight (Mw) of the polycarbonate resin included in the immobilizing resin layer (C) is 1000 or more, the resin composition for forming the immobilizing resin layer (C) exhibits improved wettability with the support substrate 50, and exhibits improved film-forming capability.

The content of the hot-melt resin that decreases in melting temperature when heated in the presence of an acid or a base in the immobilizing resin layer (C) is preferably 10 to 100 wt%, and particularly preferably 30 to 100 wt%. When the content of the hot-melt resin that decreases in melting temperature when heated in the presence of an acid or a base in the immobilizing resin layer (C) is 10 wt% or more, it is possible to reliably reduce the adhesion of the immobilizing resin layer to the encapsulating material cured product 80.

Since the thermally decomposable resin that is included in the immobilizing resin layer (B) and decreases in thermal decomposition temperature when heated in the presence of an acid or a base (e.g., polycarbonate resin, polyester resin, polyamide resin, polyether resin, and polyurethane resin described in connection with the immobilizing resin layer (A)) also decreases in molecular weight since the molecular chains of the resin are cut in the presence of an acid or a base, the thermally decomposable resin may be used as the hot-melt resin that is included in the immobilizing resin layer (C) and decreases in melting temperature when heated in the presence of an acid or a base.

The photoacid generator or the photobase generator included in the immobilizing resin layer (C) is the same as the photoacid generator or the photobase generator included in the immobilizing resin layer (B).

The content of the photoacid generator or the photobase generator in the immobilizing resin layer (C) is preferably about 0.01 to about 50 wt%, and particularly preferably about 0.1 to about 30 wt%. When the content of the photoacid generator or the photobase generator in the immobilizing resin layer (C) is within the above range, the melting temperature of the resin can be stably reduced to a temperature within the desired range.

It is preferable that the melting temperature of the immobilizing resin layer (C) after applying active energy rays to the immobilizing resin layer (C) (i.e., the melting temperature of the hot-melt resin included in the immobilizing resin layer (C) that decreases in melting temperature when heated in the presence of an acid or a base) be 100 to 200°C, and particularly preferably 120 to 190°C.

It is preferable that the immobilizing resin layer (C) have a melt viscosity at 180°C of 0.01 to 100 Pa·s after applying active energy rays to the immobilizing resin layer (C).

The immobilizing resin layer 60 (e.g., immobilizing resin layer (A), immobilizing resin layer (B), or immobilizing resin layer (C)) may include an antioxidant. The antioxidant prevents production of an undesirable acid, and prevents spontaneous oxidation of the immobilizing resin layer 60.

The antioxidant is not particularly limited. For example, Ciba IRGANOX (registered trademark) 1076 or Ciba IRGAFOS (registered trademark) 168 (available from Ciba Fine Chemicals (Tarrytown, New York) may suitably be used.

Further examples of the antioxidant include Ciba Irganox (registered trademark) 129, Ciba Irganox 1330, Ciba Irganox 1010, Ciba Cyanox (registered trademark) 1790, Ciba Irganox 3114, Ciba Irganox 3125, and the like.

The antioxidant is preferably used in an amount of 0.1 to 10 parts by weight, and particularly preferably 0.5 to 5 parts by weight, based on 100 parts by weight of the resin included in the immobilizing resin layer 60.

The immobilizing resin layer 60 (e.g., immobilizing resin layer (A), immobilizing resin layer (B), or immobilizing resin layer (C)) may optionally include a leveling agent (e.g., acrylic leveling agent, silicone leveling agent, fluorine-containing leveling agent, and vinyl leveling agent), a silane coupling agent, and the like.

Examples of the silane coupling agent that may be included in the immobilizing resin layer 60 include, but are not limited to, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, N-phenyl-3-aminopropyltrimethoxysilane, 3-mercaptopropylmethyldimethoxysilane, 3-mercaptopropyltrimethoxysilane, bis(triethoxypropyl) tetrasulfide, 3-isocyanatepropyltriethoxysilane, and the like. These silane coupling agents may be used either alone or in combination. When the immobilizing resin layer 60 includes the silane coupling agent, the immobilizing resin layer 60 exhibits improved adhesion to the electronic parts 40 and the support substrate 50.

[3] The electronic parts 40 are disposed on the immobilizing resin layer 60, and immobilized on the support substrate 50 via the immobilizing resin layer 60 (FIG. 2(c), electronic part-immobilizing step).

The electronic parts 40 are disposed so that the side of the electronic part 40 provided with terminals (not illustrated in FIG 2(c)) faces downward (i.e., comes in contact with the immobilizing resin layer 60). The electronic parts 40 are disposed so that a space 42 is formed between the adjacent electronic parts 40. In other words, the electronic parts 40 are arranged at intervals corresponding to the space 42. In FIG 2(c), the electronic parts 40 are disposed so that a constant space is formed between the adjacent electronic parts 40 in the rightward/leftward direction. Note that the electronic parts 40 are also disposed in the depth direction in FIG 2(c) so that a space is formed between the adjacent electronic parts 40. It is necessary to accurately dispose the electronic parts 40 so that a wiring layer can be accurately formed in the wiring layer-forming step.

The electronic parts 40 may be disposed by an arbitrary method. For example, the electronic parts 40 can be accurately disposed by utilizing a flip-chip bonder.

The electronic parts 40 may be immobilized on the immobilizing resin layer 60 by an arbitrary method. When the immobilizing resin layer 60 is liquid, the electronic parts 40 can be immobilized on the immobilizing resin layer 60 by pressing the electronic parts 40 (including a case of utilizing only the weight of the electronic parts 40). When the immobilizing resin layer 60 is solid, the electronic parts 40 can be immobilized on the immobilizing resin layer 60 by appropriately heating and pressing the electronic parts 40. The heating temperature employed when immobilizing the electronic parts 40 on the immobilizing resin layer 60 is not particularly limited, but is preferably 50 to 200°C, and particularly preferably 80 to 180°C. The pressure applied when immobilizing the electronic parts 40 on the immobilizing resin layer 60 is preferably 0.05 to 1 MPa, and particularly preferably 0.1 to 0.8 MPa. The heating time and the pressing time employed when immobilizing the electronic parts 40 on the immobilizing resin layer 60 are preferably 0.1 to 30 seconds, and particularly preferably 1 to 15 seconds. It is possible to reliably immobilize the electronic parts 40 while preventing breakage and deformation of the electronic parts 40 by setting the heating conditions and the pressing conditions within the above range when immobilizing the electronic parts 40 on the immobilizing resin layer 60.

[4] The encapsulating material layer 70 is formed on the electronic parts 40 and the immobilizing resin layer 60 using a encapsulating material so that the spaces 42 between the electronic parts 40 and the electronic parts 40 are covered with the encapsulating material layer 70 (FIG. 2(d), encapsulating material layer-forming step).

Note that the entirety of the electronic parts 40 may be covered with the encapsulating material layer 70, or only pert of the electronic parts 40 may be covered with the encapsulating material layer 70. It is preferable that the entirety of the electronic parts 40 be covered with the encapsulating material layer 70 since the reliability of the electronic device 30 is improved.

The encapsulating material layer 70 is formed by an arbitrary method using the encapsulating material. The encapsulating material layer 70 may be formed using a transfer molding method, a compression molding method, an injection molding method, or the like. It is preferable to form the encapsulating material layer 70 using a compression molding method since the immobilized electronic parts 40 are rarely displaced. The molding temperature employed when molding the encapsulating material is not particularly limited, but is preferably 50 to 200°C, and particularly preferably 80 to 180°C. The molding pressure employed when molding the encapsulating material is not particularly limited, but is preferably 0.5 to 12 MPa, and particularly preferably 1 to 10 MPa. The molding time employed when molding the encapsulating material is preferably 30 seconds to 15 minutes, and particularly preferably 1 to 10 minutes. It is possible to prevent occurrence of an area that is not filled with the encapsulating material while preventing displacement of the electronic parts 40 by setting the molding temperature, the molding pressure, and the molding time when molding the encapsulating material within the above range.

The encapsulating material is not particularly limited. A liquid encapsulating material or a solid encapsulating material may be used. It is preferable to use a encapsulating material that mainly includes an epoxy resin, a curing agent, and an inorganic filler, for example. A encapsulating material that include such materials can encapsulat the electronic parts 40 with excellent adhesion, and allows the coefficient of thermal expansion to be adjusted relatively easily.

The details of the liquid encapsulating material are described below. Note that the liquid encapsulating material is not limited thereto.

The liquid encapsulating material is not particularly limited, but preferably includes an epoxy resin, an acid anhydride, an inorganic filler, and a curing accelerator as essential components. A phosphonium salt curing accelerator is preferable as the curing accelerator.

The epoxy resin included in the liquid encapsulating material is not particularly limited. The molecular weight and the structure of the epoxy resin are not particularly limited as long as the epoxy resin includes two or more epoxy groups in one molecule, and is liquid at room temperature.

Examples of the epoxy resin included in the liquid encapsulating material include novolac epoxy resins such as a phenol novolac epoxy resin and a cresol novolac epoxy resin, aromatic glycidyl amine epoxy resins such as a bisphenol F epoxy resin, N,N-diglycidylaniline, N,N-diglycidyltoluidine, diaminodiphenylmethaneglycidylamine, and aminophenolglycidylamine, aralkyl epoxy resins such as a hydroquinone epoxy resin, a biphenyl epoxy resin, a stilbene epoxy resin, a triphenolmethane epoxy resin, a triphenolpropane epoxy resin, an alkyl-modified triphenolmethane epoxy resin, a triazine nucleus-containing epoxy resin, a dicyclopentadiene-modified phenol epoxy resin, a naphthol epoxy resin, a naphthalene epoxy resin, a phenolaralkyl epoxy resin that includes a phenylene and/or biphenylene skeleton, and a naphtholaralkyl epoxy resin that includes a phenylene and/or biphenylene skeleton, and aliphatic epoxy resins such as alicyclic epoxy resins such as vinylcyclohexene dioxide, dicyclopentadiene oxide, and an alicyclic diepoxy-adipate.

An epoxy resin having a structure in which a glycidyl ether structure or a glycidylamine structure is bonded to an aromatic ring is preferable as the epoxy resin included in the liquid encapsulating material from the viewpoint of heat resistance, mechanical properties, and moisture resistance. When using an aliphatic or alicyclic epoxy resin as the epoxy resin included in the liquid encapsulating material, it is preferable to limit the content of the aliphatic or alicyclic epoxy resin from the viewpoint of reliability (particularly adhesion). These epoxy resins may be used either alone or in combination. It is preferable that the epoxy resin included in the encapsulating material be liquid at room temperature (25°C). When using an epoxy resin that is solid at room temperature, the epoxy resin that is solid at room temperature may be dissolved in an epoxy resin that is liquid at room temperature to prepare a liquid encapsulating material.

Examples of the acid anhydride included in the liquid encapsulating material include phthalic anhydride, maleic anhydride, trimellitic anhydride, pyromellitic anhydride, hexahydrophthalic anhydride, 3-methylhexahydrophthalic anhydride, 4-methylhexahydrophthalic anhydride, a mixture of 3-methylhexahydrophthalic anhydride and 4-methylhexahydrophthalic anhydride, tetrahydrophthalic anhydride, nadic anhydride, methylnadic anhydride, and the like. These compounds are preferable due to a high curing speed at a low temperature, and an increase in glass transition temperature of a cured product of the encapsulating material. It is particularly preferable to use tetrahydrophthalic anhydride as the acid anhydride included in the liquid encapsulating material since tetrahydrophthalic anhydride is liquid at room temperature and has low viscosity. Note that these compounds may be used either alone or in combination.

The content of the acid anhydride in the encapsulating material is preferably 2 to 10 wt%, and particularly preferably 5 to 7 wt%. If the content of the acid anhydride in the encapsulating material is less than 2 wt%, the productivity may decrease due to poor curability. If the content of the acid anhydride in the encapsulating material exceeds 10 wt%, moisture-proof reliability may decrease.

The liquid encapsulating material may include a curing agent other than the acid anhydride. Examples of the curing agent other than the acid anhydride that may be used together with the acid anhydride include monomers, oligomers, and polymers that include a functional group that reacts with an epoxy group in one molecule. Specific examples of the curing agent other than the acid anhydride include phenol resins such as a phenol novolac resin, a cresol novolac resin, a dicyclopentadiene-modified phenol resin, a terpene-modified phenol resin, a triphenolmethane resin, and a phenolaralkyl resin (e.g., a phenolaralkyl resin including a phenylene skeleton or a diphenylene skeleton).

Examples of the inorganic filler included in the liquid encapsulating material include those normally used for a encapsulating material. Specific examples of the inorganic filler include fused silica, crystalline silica, talc, alumina, silicon nitride, and the like. These inorganic fillers may be used either alone or in combination. It is preferable to use fused silica, crystalline silica, or a synthetic silica powder as the inorganic filler since the heat resistance, the moisture resistance, the strength, and the like of a cured product of the encapsulating material can be improved.

The shape of the inorganic filler is not particularly limited. It is preferable to use a spherical inorganic filler from the viewpoint of viscosity and flow properties.

When using fused silica as the inorganic filler, the content of fused silica in the liquid encapsulating material is preferably 30 to 90 wt%, and particularly preferably 40 to 85 wt%, from the viewpoint of the balance between moldability and solder crack resistance. If the content of fused silica in the liquid encapsulating material is less than 30 wt%, the solder crack resistance may decrease due to an increase in water absorption. If the content of fused silica in the liquid encapsulating material exceeds 90 wt%, the dispensing performance of the liquid encapsulating material may deteriorate. When using an inorganic filler other than fused silica, the content of the inorganic filler in the liquid encapsulating material is preferably 30 to 90 vol%, and particularly preferably 40 to 85 vol%.

The curing accelerator included in the liquid encapsulating material is not particularly limited, but is preferably a phosphonium salt curing accelerator. Examples of the phosphonium salt curing accelerator include, but are not limited to, a phosphonium salt curing accelerator having a structure shown by the following general formula (4) or (5).

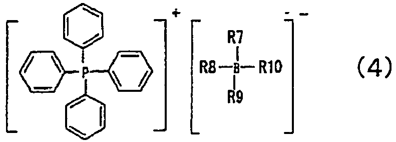

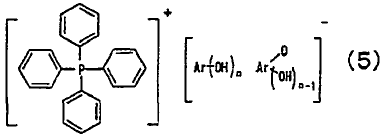

wherein R7, R8, R9, and R10 independently represent a monovalent organic group or a monovalent aliphatic group that includes an aromatic ring or a heterocyclic ring, provided that at least one of R7, R8, R9, and R10 represents a group obtained when a proton donor that has at least one proton has released one proton, Ar represents a substituted or unsubstituted aromatic group, provided that two oxygen atoms in the same molecule are positioned adjacent to an aromatic carbon, and n is an integer from 2 to 12.

It is possible to improve the adhesion of a cured product of the liquid encapsulating material to the electronic parts and the immobilizing resin layer 60 by utilizing the phosphonium salt curing accelerator having the structure shown by the general formula (4) or (5).

Examples of the phosphonium salt curing accelerator having the structure shown by the general formula (4) include the phosphonium salt curing accelerators shown by the following formulas (6), (7), and (8).

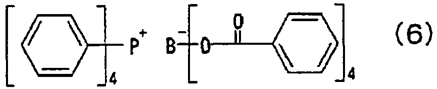

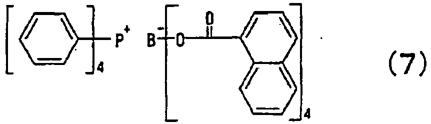

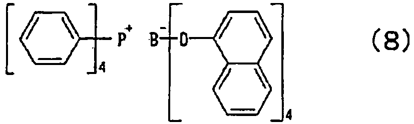

Examples of the phosphonium salt curing accelerator having the structure shown by the general formula (5) include the phosphonium salt curing accelerators shown by the following formulas (9), (10), and (11).

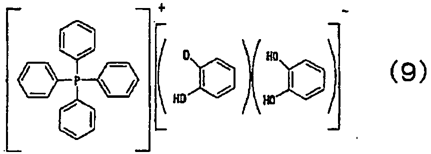

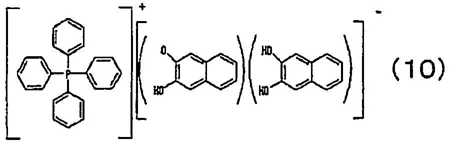

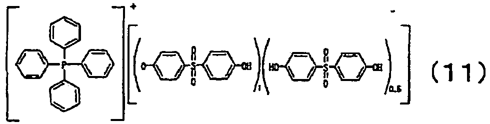

Among these, the phosphonium salt curing accelerators shown by the formula (7) or (11) are preferable since an excellent balance between curability and adhesion is achieved.

The content of the curing accelerator in the liquid encapsulating material is preferably 0.1 to 1.0 wt%, and particularly preferably 0.3 to 0.8 wt%. If the content of the curing accelerator in the liquid encapsulating material is less than 0.1 wt%, the productivity may decrease due to poor curability. If the content of the curing accelerator in the liquid encapsulating material exceeds 1.0 wt%, the storage stability may deteriorate.

The ratio of the content of the acid anhydride to the content of the curing accelerator in the liquid encapsulating material is preferably 3 to 35, more preferably 5 to 30, and particularly preferably 10 to 20. If the ratio of the content of the acid anhydride to the content of the curing accelerator in the liquid encapsulating material is less than 3, the storage stability may deteriorate. If the ratio of the content of the acid anhydride to the content of the curing accelerator in the liquid encapsulating material exceeds 35, the productivity may decrease due to poor curability.

Examples of an additional component that may be included in the liquid encapsulating material include an anti-foaming agent (e.g., silicone compound), a release agent (e.g., wax), and a stress-reducing agent (e.g., silicone robber).

The liquid encapsulating material may be prepared by an arbitrary method. For example, the liquid encapsulating material may be prepared by dispersing and kneading the epoxy resin, the acid anhydride, the inorganic filler, the curing accelerator, additives, and the like using a planetary mixer, a triple roll, a double hot roll, an automatic mortar, or the like, and defoaming the mixture under vacuum.

The details of the solid encapsulating material are described below. Note that the solid encapsulating material is not limited thereto.

Examples of the epoxy resin included in the solid encapsulating material include crystalline epoxy resins such as a biphenyl epoxy resin, a bisphenol A epoxy resin, a bisphenol F epoxy resin, a stilbene epoxy resin, and a hydroquinone epoxy resin; novolac epoxy resins such as a cresol novolac epoxy resin, a phenol novolac epoxy resin, and a naphthol novolac epoxy resin; phenolaralkyl epoxy resins such as a phenylene skeleton-containing phenolaralkyl epoxy resin, a biphenylene skeleton-containing phenolaralkyl epoxy resin, and a phenylene skeleton-containing naphtholaralkyl epoxy resin; trifunctional epoxy resins such as a triphenolmethane epoxy resin and an alkyl-modified triphenolmethane epoxy resin; modified phenol epoxy resins such as a dicyclopentadiene-modified phenol epoxy resin and a terpene-modified phenol epoxy resin; heterocyclic ring-containing epoxy resins such as a triazine nucleus-containing epoxy resin; and the like. These epoxy resins may be used either alone or in combination.

It is preferable to use an epoxy resin shown by the following general formula (12) as the epoxy resin included in the solid encapsulating material. Since the epoxy resin shown by the general formula (12) is a bifunctional epoxy resin, a cured product of the encapsulating material that includes the epoxy resin shown by the general formula (12) exhibits a low crosslink density, has a low coefficient of thermal expansion, and is suitable for reducing stress when heating the electronic device 30 in a solder reflow step (i.e., the degree of warping is reduced). Since the epoxy resin shown by the general formula (12) is a crystalline resin having a low molecular weight and a low melt viscosity, the encapsulating material that includes the epoxy resin shown by the general formula (12) exhibits excellent fluidity.

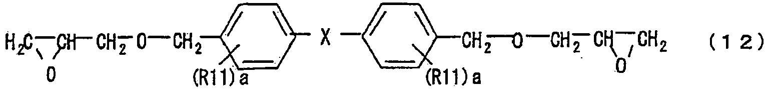

wherein X represents a single bond or a group selected from -O-, -S-, and -R12CR12-, R11 independently represent an alkyl group having 1 to 6 carbon atoms, a is an integer from 0 to 4, and R12 independently represent an alkyl group having 1 to 4 carbon atoms.

It is preferable to use 4,4'-diglycidoxybiphenyl, 3,3',5,5'-tetramethyl-4,4'-diglycidoxybiphenyl, or a fused mixture thereof as the epoxy resin shown by the general formula (12) since an excellent balance between workability and utility is obtained, and the coefficient of thermal expansion of the encapsulating material cured product layer 71 can be reduced.

The solid encapsulating material preferably includes the epoxy resin, a curing agent, and an inorganic filler as essential components.

Examples of the curing agent included in the solid encapsulating material include amines such as linear aliphatic diamines having 2 to 20 carbon atoms, such as ethylenediamine, trimethylenediamine, tetramethylenediamine, and hexamethylenediamine, m-phenylenediamine, p-phenylendiamin, p-xylenediamine, 4,4'-diaminodiphenylmethane, 4,4'-diaminodiphenylpropane, 4,4'-diamino diphenyl ether, 4,4'-diaminodiphenylsulfone, 4,4'-diaminodicyclohexane, bis(4-aminophenyl)phenylmethane, 1,5-diaminonaphthalene, m-xylenediamine, p-xylenediamine, 1,1-bis(4-aminophenyl)cyclohexane, and dicyanodiamide; resol phenol resins such as an aniline-modified resol resin and a dimethyl ether resol resin; novolac phenol resins such as a phenol novolac resin, a cresol novolac resin, a tert-butylphenol novolac resin, and a nonylphenol novolac resin; phenolaralkyl resins such as a phenylene skeleton-containing phenolaralkyl resin and a biphenylene skeleton-containing phenolaralkyl resin; phenol resins including a fused polycyclic structure such as a naphthalene skeleton or an anthracene skeleton; polyoxystyrenes such as poly(p-oxystyrene); acid anhydrides such as alicyclic acid anhydrides such as hexahydrophthalic anhydride (HHPA) and methyltetrahydrophthalic anhydride (MTHPA), and aromatic acid anhydrides such as trimellitic anhydride (TMA), pyromellitic dianhydride (PMDA), and benzophenonetetracarboxylic acid (BTDA); polymercaptan compounds such as a polysulphide, a thioester, and a thioether; isocyanate compounds such as an isocyanate prepolymer and a blocked isocyanate; and organic acids such as a carboxylic acid-containing polyester resin. These curing agents may be used either alone or in combination.

Among these, it is preferable to use a compound that includes at least two phenolic hydroxyl groups in one molecule as the curing agent included in the solid encapsulating material. Examples of such a curing agent include novolac phenol resins such as a phenol novolac resin, a cresol novolac resin, a tert-butylphenol novolac resin, and a nonylphenol novolac resin; a resol phenol resin; polyoxystyrenes such as poly(p-oxystyrene); phenylene skeleton-containing phenolaralkyl resins; biphenylene skeleton-containing phenolaralkyl resins; and the like. The encapsulating material cured product layer 71 has a low coefficient of thermal expansion, and exhibits excellent moisture resistance, reliability, and the like when using such as compound as the curing agent included in the solid encapsulating material.

A phenol resin shown by the following general formula (13) is particularly preferable as the curing agent that includes at least two phenolic hydroxyl groups in one molecule. The basic skeleton of the phenol resin shown by the following general formula (13) includes the structure of a novolac phenol resin and the structure of a triphenolmethane phenol resin. The phenol resin shown by the following general formula (13) has advantages in that the distance between the crosslinked points of the resin skeleton is short, and excellent curability and moldability are obtained due to the structure of the novolac phenol resin. The phenol resin shown by the following general formula (13) also has advantages in that the crosslink density increases due to three or more hydroxyl groups in one molecule due to the structure of the triphenolmethane phenol resin, so that the cured product has a high Tg, a small coefficient of linear expansion, and high strength. Therefore, the solid encapsulating material that includes the phenol resin shown by the general formula (13) exhibits excellent curability and excellent moldability, and shows relatively small thermal expansion and thermal shrinkage after molding, curing, and heating. As a result, the amount of warping of the electronic device 30 can be reduced.

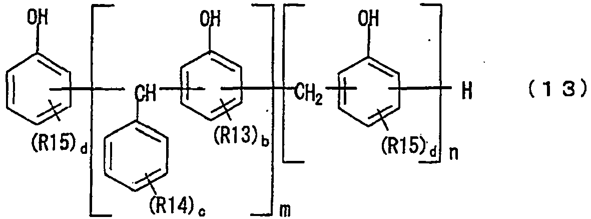

wherein R13, R14, and R15 independently represent an alkyl group having 1 to 4 carbon atoms, b is an integer from 0 to 3, c is an integer from 0 to 4, d is an integer from 0 to 3, and m and n define a molar ratio, provided that 0<m<1, 0<n<1, and m+n=1 are satisfied.

The molar ratio "m/n" in the general formula (13) is preferably 1/5 to 5/1, and more preferably 1/2 to 2/1. This makes it possible to synergistically achieve the effects of the novolac phenol resin and the novolac phenol resin.

Specific examples of the phenol resin shown by the general formula (13) include a phenol resin shown by the following formula (14).

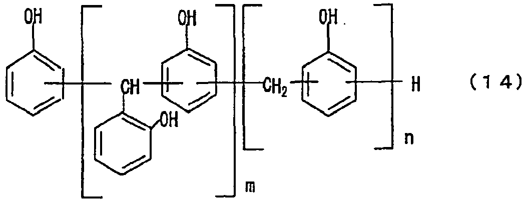

wherein m and n define a molar ratio, provided that 0<m<1, 0<n<1, and m+n=1 are satisfied.

Examples of the inorganic filler included in the solid encapsulating material include silica such as fused/crushed silica, fused spherical silica, crystalline silica, and silica secondary aggregates; alumina; titanium white; aluminum hydroxide; talc; clay; mica; glass fibers; and the like. These inorganic fillers may be used either alone or in combination. It is preferable to use fused spherical silica as the inorganic filler since the coefficient of thermal expansion of the encapsulating material cured product layer 71 can be reduced.

It is preferable that the inorganic filler has as high sphericity as possible. The filler content can be increased by utilizing inorganic fillers that differ in particle size in combination. The particle size of the inorganic filler is preferably 0.01 to 150 µm so that the space between the electronic parts 40 can be sufficiently filled with the inorganic filler.

The solid encapsulating material may include a silane coupling agent, a compound in which a hydroxyl group is respectively bonded to two or more adjacent carbon atoms of an aromatic ring, and a curing accelerator in addition to the epoxy resin, the curing agent, and the inorganic filler.

Examples of the silane coupling agent that may be included in the solid encapsulating material include, but are not limited to, epoxysilanes, aminosilanes, ureidosilanes, mercaptosilanes, and the like. These silane coupling agents may be used either alone or in combination. When the solid encapsulating material includes such a silane coupling agent, a reaction occurs between the epoxy resin and the inorganic filler, so that the interfacial strength of the epoxy resin and the inorganic filler can be improved.

Examples of the epoxysilanes include γ-glycidoxypropyltriethoxysilane, γ-glycidoxypropyltrimetoxysilane, γ-glycidoxypropylmethyldimethoxysilane, β-(3,4-epoxycyclohexyl)ethyltrimethoxysilane, and the like. Examples of the aminosilanes include γ-aminopropyltriethoxysilane, γ-aminopropyltrimethoxysilane, N-β-(aminoethyl)-γ-aminopropyltimethoxysilane, N-β-(aminoethyl)-γ-aminopropylmethyldimethoxysilane, N-phenyl-y-aminopropyltriethoxysilane, N-phenyl-γ-aminopropyltrimethoxysilane, N-β-(aminoethyl)-γ-aminopropyltriethoxysilane, N-6-(aminohexyl)-3-aminopropyltrimethoxysilane, N-(3-(trimethoxysilylpropyl))-1,3-benzenedimethane, and the like. Examples of the ureidosilanes include γ-ureidopropyltriethoxysilane, hexamethyldisilazane, and the like. Examples of the mercaptosilanes include γ-mercaptopropyltrimethoxysilane.

The silane coupling agent that may be included in the solid encapsulating material reduces the viscosity of the resin composition, and improves the fluidity of the resin composition due to a synergistic effect with the compound in which a hydroxyl group is respectively bonded to two or more adjacent carbon atoms of an aromatic ring (hereinafter may be referred to as "hydroxyl group-bonded compound"). Therefore, when the encapsulating material includes the hydroxyl group-bonded compound, it is preferable to use the silane coupling agent in combination with the hydroxyl group-bonded compound so that the effect obtained by adding the hydroxyl group-bonded compound is sufficiently achieved. In this case, the solid encapsulating material exhibits sufficient fluidity even when using a large amount of resin that exhibits relatively high viscosity, or using a large amount of inorganic filler.

Examples of the compound in which a hydroxyl group is respectively bonded to two or more adjacent carbon atoms of an aromatic ring (hydroxyl group-bonded compound) include a compound shown by the following general formula (15), a compound shown by the following general formula (16), and the like. Note that the hydroxyl group-bonded compound may be substituted with a substituent other than a hydroxyl group.

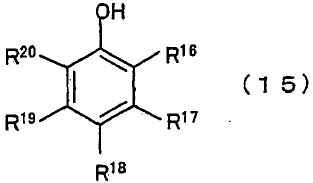

wherein one of R16 and R20 represents a hydroxyl group, the other of R16 and R20 represents a hydrogen atom or a group selected from a hydroxyl group and a substituent other than a hydroxyl group, and R17, R18, and R19 independently represent a hydrogen atom or a group selected from a hydroxyl group and a substituent other than a hydroxyl group.

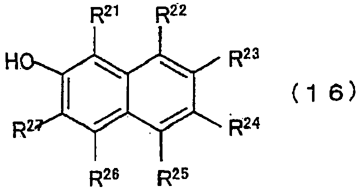

wherein one of R21 and R27 represents a hydroxyl group, the other of R21 and R27 represents a hydrogen atom or a group selected from a hydroxyl group and a substituent other than a hydroxyl group, and R22, R23, R24, R25, and R26 independently represent a hydrogen atom or a group selected from a hydroxyl group and a substituent other than a hydroxyl group.

Specific examples of the compound shown by the general formula (15) include catechol (see formula (17)), pyrogallol, gallic acid, gallic acid ester, and derivatives thereof. Specific examples of the compound shown by the general formula (16) include 1,2-dihydroxynaphthalene, 2,3-dihydroaynaphthalene (see formula (18)), and derivatives thereof. These compounds may be used either alone or in combination. It is preferable to use a compound that includes a naphthalene ring as the main skeleton (i.e., 1,2-dihydroxynaphthalene, 2,3-dihydroxynaphthalene, or a derivative thereof) due to ease of fluidity/curability control and low volatility.

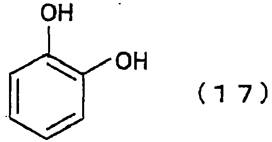

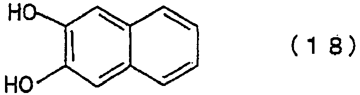

Examples of the curing accelerator that may be included in the solid encapsulating material include, but are not limited to, diazabicycloalkenes and derivatives thereof such as 1,8-diazabicyclo(5,4,0)undecene-7; amine compounds such as tributylamine and benzyldimethylamine; imidazole compounds such as 2-methylimidazole; organic phosphines such as triphenylphosphine and methyldiphenylphosphine; tetra-substituted phosphonium tetra-substituted borates such as tetraphenylphosphonium tetraphenylborate, tetraphenylphosphonium tetrabenzoic acid borate, tetraphenylphosphonium tetranaphthoic acid borate, tetraphenylphosphonium tetranaphthoyloxyborate, and tetraphenylphosphonium tetranaphthyloxyborate; triphenylphosphine to which benzoquinone is added; and the like. These curing accelerators may be used either alone or in combination.

The solid encapsulating material may optionally further include a coloring agent such as carbon black; a release agent such as natural wax such as carnauba wax, a higher fatty acid or a metal salt thereof, paraffin, and polyethylene oxide; a stress-reducing agent such as silicone oil and silicone rubber; an ion scavenger such as hydrotalcite; a flame retardant such as aluminum hydroxide; an antioxidant; and the like.

The encapsulating material is molded using a transfer molding method, a compression molding method, an injection molding method, or the like. The molding method is not particularly limited. It is preferable to use a compression molding method from the viewpoint of preventing displacement and removal of the electronic parts.

The method (1) and the method (2) differ as to the step subsequent to the encapsulating material layer-forming step.

### When using method (1)

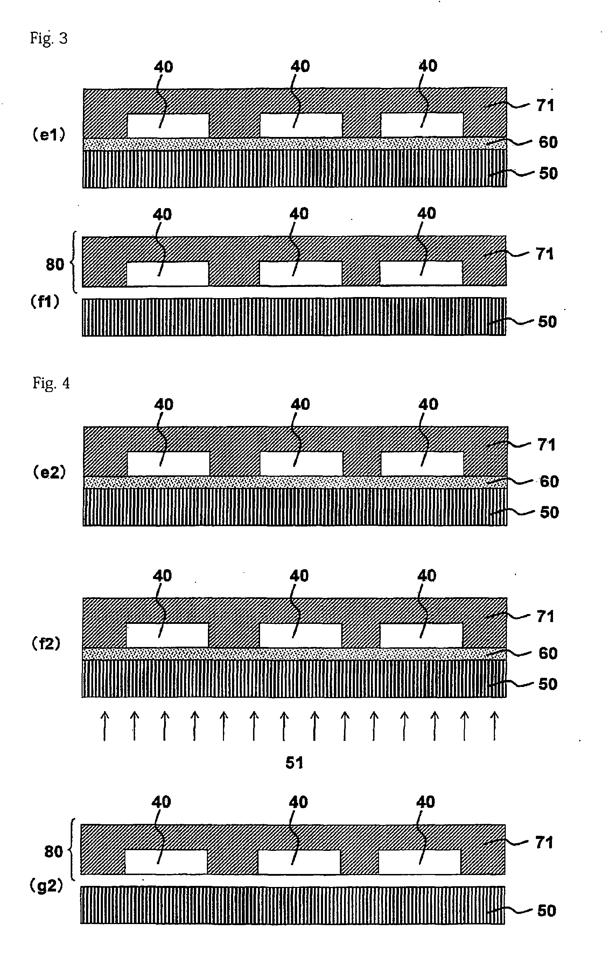

[5] According to the method (1) (e.g., (1A), (1B), or (1C)), the encapsulating material layer 70 is heated and cured to obtain a encapsulating material cured product 80 in which the electronic parts 40 are disposed (FIG 3(e1) or 4(e2), encapsulating material-curing step). In the encapsulating material-curing step and the removal step of the methods (1B) and (1C), the encapsulating material is heated, and irradiated with active energy rays, and the immobilizing resin layer is then heated as illustrated in FIG 4.

The encapsulating material layer 70 may be cured under arbitrary conditions. Note that the heating temperature is set to be lower than the temperature at which the immobilizing resin layer 60 is thermally decomposed or melted (i.e., the thermal decomposition temperature or the melting temperature of the resin included in the immobilizing resin layer 60). This makes it possible to prevent displacement of the encapsulating material cured product 80. The heating temperature employed when curing the encapsulating material layer 70 is preferably 100 to 200°C, and particularly preferably 120 to 190°C. The heating time employed when curing the encapsulating material layer 70 is not particularly limited, but is preferably 30 minutes to 8 hours, and particularly preferably 1 to 6 hours. It is possible to prevent a situation in which the immobilizing resin layer 60 thermally decomposed or melted while improving the reliability of the electronic device 3 0 by setting the heating temperature and the heating time employed when curing the encapsulating material layer 70 within the above range. The encapsulating material layer 70 forms the encapsulating material cured product layer 71 as a result of curing the encapsulating material by heating the encapsulating material layer 70 at a temperature higher than the curing temperature. Specifically, the spaces 42 between the electronic parts 40 and the electronic parts 40 are covered with the encapsulating material cured product by curing the encapsulating material, so that the encapsulating material cured product layer 71 is formed on the electronic parts 40 and the immobilizing resin layer 60.

[6] The encapsulating material cured product 80 is then removed from the support substrate (removal step). In the removal step of the method (1A), the encapsulating material cured product 80 is removed from the support substrate by thermally decomposing the immobilizing resin layer 60 by heating the immobilizing resin layer 60 (FIG 3(f1), removal step).

The heating temperature employed when heating the immobilizing resin layer 60 in the removal step of the method (1A) is not particularly limited, but is preferably 200 to 400°C, and particularly preferably 220 to 350°C. The heating time employed when heating the immobilizing resin layer 60 is not particularly limited, but is preferably 30 seconds to 60 minutes, and particularly preferably 1 to 30 minutes. It is possible to reliably thermally decompose the immobilizing resin layer 60 while effectively preventing thermal deterioration of the electronic parts 40 and the encapsulating material layer 70 by setting the heating temperature and the heating time employed when heating the immobilizing resin layer 60 within the above range.

In the removal step of the method (1B), active energy rays are applied to the immobilizing resin layer 60 (FIG 4(f2)), and the encapsulating material cured product 80 is removed from the support substrate by thermally decomposing the immobilizing resin layer 60 to which the active energy rays have been applied by heating the immobilizing resin layer 60 (FIG. 4(g2)).

In the removal step of the method (1B), active energy rays are applied to the immobilizing resin layer 60 through the support substrate 50. The active energy rays are not particularly limited. For example, it is preferable to use active energy rays having a wavelength of about 200 to about 500 nm, and it is particularly preferable to use active energy rays having a wavelength of about 350 to about 400 nm. The dose of the active energy rays is not particularly limited, but is preferably about 1 to about 2000 mJ/cm², and particularly preferably about 10 to about 1000 mJ/cm².

In the removal step of the method (1B), the immobilizing resin layer 60 is then heated. The heating temperature employed when heating the immobilizing resin layer 60 is not particularly limited, but is preferably 100 to 200°C, and particularly preferably 120 to 190°C. The heating time employed when heating the immobilizing resin layer 60 is not particularly limited, but is preferably 30 seconds to 60 minutes, and particularly preferably 1 to 30 minutes. It is possible to reliably thermally decompose the immobilizing resin layer 60 while effectively preventing thermal deterioration of the electronic parts 40 and the encapsulating material layer 70 by setting the heating temperature and the heating time employed when heating the immobilizing resin layer 60 within the above range. The thermally decomposable resin that is included in the immobilizing resin layer 60 and decreases in thermal decomposition temperature when heated in the presence of an acid or a base is selected so that the immobilizing resin layer 60 to which the active energy rays have been applied is preferably thermally decomposed at 100 to 200°C, and particularly preferably 120 to 190°C in the removal step of the method (1B).

In the removal step of the method (1C), active energy rays are applied to the immobilizing resin layer 60 (FIG 4(f2)), and the encapsulating material cured product 80 is removed from the support substrate by melting the immobilizing resin layer 60 to which the active energy rays have been applied by heating the immobilizing resin layer 60 (FIG. 4(g2)). In FIG 4(g2), the immobilizing resin layer 60 does not adhere to the encapsulating material cured product 80 and the support substrate 50. Note that FIG 4(g2) illustrates only the encapsulating material cured product 80 and the support substrate 50 so that it is readily understood that the encapsulating material cured product 80 is separated from the support substrate 50. In the actual removal step, the melted immobilizing resin layer 60 adheres to the surface of the encapsulating material cured product 80 and the surface of the support substrate 50. The encapsulating material cured product 80 and the support substrate 50 illustrated in FIG 4(g2) are obtained by removing the immobilizing resin layer 60 from the surface of the encapsulating material cured product 80 and the surface of the support substrate 50 as described below.

In the removal step of the method (1C), active energy rays are applied to the immobilizing resin layer 60 through the support substrate 50. The active energy rays are not particularly limited. For example, it is preferable to use active energy rays having a wavelength of about 200 to about 500 nm, and it is particularly preferable to use active energy rays having a wavelength of about 350 to about 400 nm. The dose of the active energy rays is not particularly limited, but is preferably about 1 to about 2000 mJ/cm², and particularly preferably about 10 to about 1000 mJ/cm².

In the removal step of the method (1C), the immobilizing resin layer 60 is then heated. The heating temperature employed when heating the immobilizing resin layer 60 is not particularly limited, but is preferably 100 to 200°C, and particularly preferably 120 to 190°C. The heating time employed when heating the immobilizing resin layer 60 is not particularly limited, but is preferably 30 seconds to 60 minutes, and particularly preferably 1 to 30 minutes. It is possible to reliably melt the immobilizing resin layer 60 while effectively preventing thermal deterioration of the electronic parts 40 and the encapsulating material layer 70 by setting the heating temperature and the heating time employed when heating the immobilizing resin layer 60 within the above range. The hot-melt resin that is included in the immobilizing resin layer 60 and decreases in melting temperature when heated in the presence of an acid or a base is selected so that the immobilizing resin layer 60 to which the active energy rays have been applied is preferably melted at 100 to 200°C, and particularly preferably 120 to 190°C in the removal step of the method (1C).

The encapsulating material cured product 80 may be removed from the support substrate by an arbitrary method. For example, the encapsulating material cured product 80 may be removed from the support substrate perpendicularly to the surface of the support substrate, may be removed from the support substrate by horizontally sliding the encapsulating material cured product 80 relative to the surface of the support substrate, or may be removed from the support substrate by floating the encapsulating material cured product 80 from the surface of the support substrate. When the immobilizing resin layer 60 adheres to the surface of the encapsulating material cured product 80 or the surface of the support substrate 50 after the removal step, the residue can be conveniently removed by a plasma treatment, a chemical treatment, a polishing treatment, or the like. It is preferable to remove the residue by a plasma treatment, or a chemical treatment using IPA, acetone, γ-butyrolactone, PGMEA, or the like that have a small environmental impact.

### When using method (2)

[5] According to the method (2) (e.g., (2A), (2B), or (2C)), the encapsulating material layer 70 is heated and cured to obtain the encapsulating material cured product 80 in which the electronic parts 40 are disposed, and remove the encapsulating material cured product 80 from the support substrate. According to the method (2), since the electronic device package 10 can be produced using a reduced number of production steps by curing the encapsulating material while removing the encapsulating material, the productivity can be improved, and the electronic device package 10 can be inexpensively produced. Note that the expression "curing the encapsulating material while removing the encapsulating material" means that the immobilizing resin layer 60 is thermally decomposed or melted by heating the immobilizing resin layer 60 when heating and curing the encapsulating material layer 70.

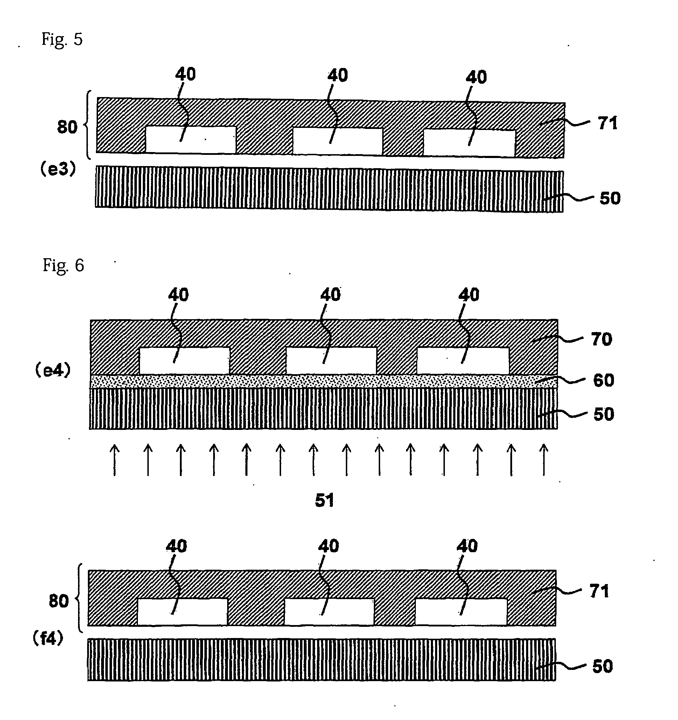

In the encapsulating material-curing/removal step of the method (2A), the encapsulating material layer 70 and the immobilizing resin layer 60 are heated without applying active energy rays to the immobilizing resin layer 60 to obtain the encapsulating material cured product 80 and remove the encapsulating material cured product 80 from the support substrate (FIG. 5(e3)). The heating temperature employed when heating the encapsulating material layer 70 and the immobilizing resin layer 60 is preferably 100 to 200°C, and particularly preferably 120 to 190°C. The heating time employed when curing the encapsulating material layer 70 and the immobilizing resin layer 60 is not particularly limited, but is preferably 30 minutes to 8 hours, and particularly preferably 1 to 6 hours. It is possible to reliably cure the encapsulating material layer 70 and thermally decompose the immobilizing resin layer 60 by setting the heating temperature and the heating time employed when heating the encapsulating material layer 70 and the immobilizing resin layer 60 within the above range. The thermally decomposable resin that is included in the immobilizing resin layer 60 is selected so that the immobilizing resin layer 60 is thermally decomposed at the temperature at which the encapsulating material layer 70 is cured (preferably 100 to 200°C, and particularly preferably 120 to 190°C) in the encapsulating material-curing/removal step of the method (2A).

In the encapsulating material-curing/removal step of the method (2B), active energy rays are applied to the immobilizing resin layer 60 (FIG. 6(e4)), and the encapsulating material layer 70 and the immobilizing resin layer 60 are heated to obtain the encapsulating material cured product 80 and remove the encapsulating material cured product 80 from the support substrate (FIG. 6(f4)). In the encapsulating material-curing/removal step of the method (2B), the active energy rays may be applied to the immobilizing resin layer 60 in the same manner as in the removal step of the method (1B). The heating temperature employed when heating the encapsulating material layer 70 and the immobilizing resin layer 60 in the encapsulating material-curing/removal step of the method (2B) is not particularly limited, but is preferably 100 to 200°C, and particularly preferably 110 to 190°C. The heating time employed when heating the encapsulating material layer 70 and the immobilizing resin layer 60 is not particularly limited, but is preferably 30 minutes to 8 hours, and particularly preferably 1 to 6 hours. It is possible to reliably cure the encapsulating material layer 70 and thermally decompose the immobilizing resin layer 60 by setting the heating temperature and the heating time employed when heating the encapsulating material layer 70 and the immobilizing resin layer 60 within the above range. The thermally decomposable resin that is included in the immobilizing resin layer 60 and decreases in thermal decomposition temperature when heated in the presence of an acid or a base is selected so that the immobilizing resin layer 60 to which the active energy rays have been applied is thermally decomposed at the temperature at which the encapsulating material layer 70 is cured (preferably 100 to 200°C, and particularly preferably 120 to 190°C) in the encapsulating material-curing/removal step of the method (2B). In the encapsulating material-curing/removal step of the methods (2B) and (2C), the encapsulating material layer and the immobilizing resin layer are heated after applying the active energy rays as illustrated in FIG: 6.

In the encapsulating material-curing/removal step of the method (2C), active energy rays are applied to the immobilizing resin layer 60 (FIG 6(e4)), and the encapsulating material layer 70 and the immobilizing resin layer 60 are heated to obtain the encapsulating material cured product 80 and remove the encapsulating material cured product 80 from the support substrate (FIG. 6(f4)). The heating temperature employed when heating the encapsulating material layer 70 and the immobilizing resin layer 60 is preferably 100 to 200°C, and particularly preferably 110 to 190°C. The heating time employed when heating the encapsulating material layer 70 and the immobilizing resin layer 60 is not particularly limited, but is preferably 30 minutes to 8 hours, and particularly preferably 1 to 6 hours. It is possible to reliably cure the encapsulating material layer 70 and melt the immobilizing resin layer 60 by setting the heating temperature and the heating time employed when heating the encapsulating material layer 70 and the immobilizing resin layer 60 within the above range. The hot-melt resin that is included in the immobilizing resin layer 60 and decreases in melting temperature when heated in the presence of an acid or a base is selected so that the immobilizing resin layer 60 to which the active energy rays have been applied is melted at the temperature at which the encapsulating material layer 70 is cured (preferably 100 to 200°C, and particularly preferably 110 to 190°C) in the encapsulating material-curing/removal step of the method (2C). In FIG 6(f4), the immobilizing resin layer 60 does not adhere to the surface of the encapsulating material cured product 80 and the surface of the support substrate 50. Note that FIG 6(f4) illustrates only the encapsulating material cured product 80 and the support substrate 50 so that it is readily understood that the encapsulating material cured product 80 is separated from the support substrate 50. In the actual encapsulating material-curing/removal step, the melted immobilizing resin layer 60 adheres to the surface of the encapsulating material cured product 80 and the surface of the support substrate 50. The encapsulating material cured product 80 and the support substrate 50 illustrated in FIG 6(f4) are obtained by removing the immobilizing resin layer 60 from the surface of the encapsulating material cured product 80 and the surface of the support substrate 50 as described below.

The encapsulating material cured product 80 may be removed from the support substrate by an arbitrary method. For example, the encapsulating material cured product 80 may be removed from the support substrate perpendicularly to the surface of the support substrate, may be removed from the support substrate by horizontally sliding the encapsulating material cured product 80 relative to the surface of the support substrate, or may be removed from the support substrate by floating the encapsulating material cured product 80 from the surface of the support substrate. When the immobilizing resin layer 60 adheres to the surface of the encapsulating material cured product 80 or the surface of the support substrate 50 after the encapsulating material-curing/removal step, the residue can be conveniently removed by a plasma treatment, a chemical treatment, a polishing treatment, or the like. It is preferable to remove the residue by a plasma treatment, or a chemical treatment using IPA, acetone, γ-butyrolactone, PGMEA, or the like that have a small environmental impact.

The encapsulating material cured product 80 is obtained in this manner.

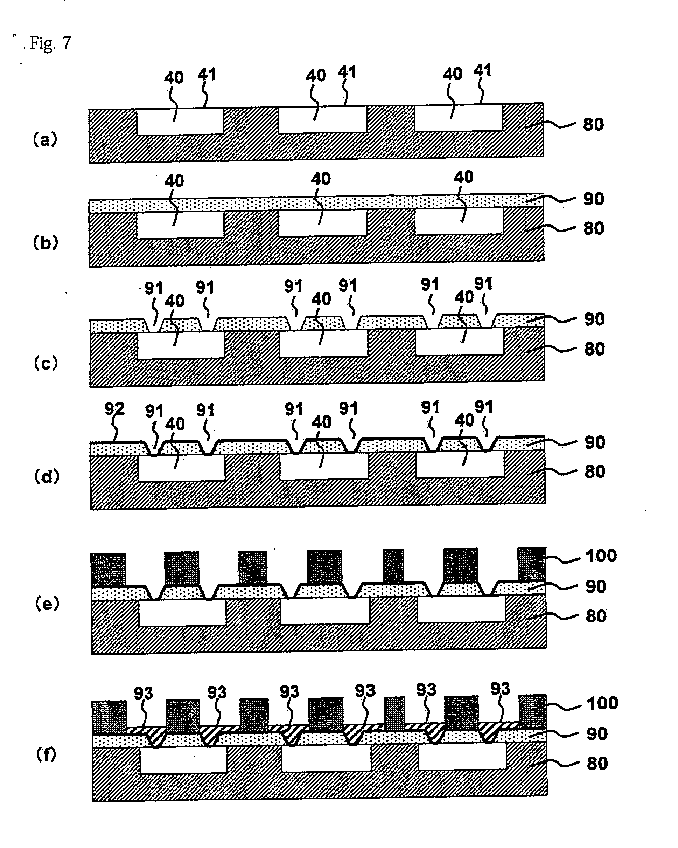

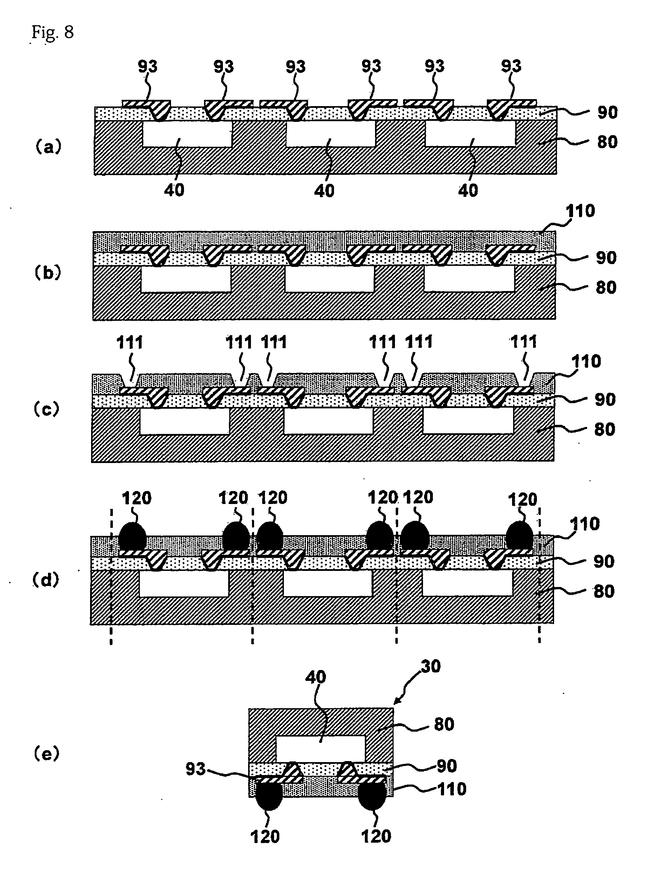

A wiring layer-forming step that forms a wiring layer on the encapsulating material cured product 80 obtained by the method (1) or (2) is described below with reference to FIGS. 7(a) to 7(e) and FIGS. 8(a) to 8(c).

[7] The encapsulating material cured product 80 is disposed so that a side 41 of the encapsulating material cured product 80 (i.e., the side of the encapsulating material cured product 80 that came in contact with the immobilizing resin layer 60) faces upward (FIG 7(a)).

[8] A first insulating layer 90 is formed on the side 41 of the encapsulating material cured product 80 (FIG. 7(b)).

The first insulating layer 90 may preferably be formed of an organic resin composition, such as a photosensitive resin composition that mainly includes a polyimide resin, a polyamide resin such as a polybenzoxazole resin, a polybenzocyclobutene resin, a polynorbornene resin, or the like. It is preferable to use a positive-type photosensitive resin composition that mainly includes a polyimide resin or a polyamide resin (e.g., polybenzoxazole resin) that exhibits excellent sensitivity and resolution during exposure and development, excellent mechanical properties (e.g., glass transition temperature and modulus of elasticity), and excellent adhesion to the encapsulating material cured product 80.

The first insulating layer 90 may be formed on the side 41 of the encapsulating material cured product 80 by an arbitrary method. For example, the first insulating layer 90 may be formed by applying the organic resin composition by a spin coating method using a spinner, a spray coating method using a spray coater, a dipping method, a printing method, a roll coating method, or the like, and prebaking the organic resin composition to volatilize the solvent included in the organic resin composition. The viscosity of the organic resin composition may be adjusted by appropriately diluting the organic resin composition with a solvent or the like.

The organic resin composition is preferably applied so that a final thickness of 0.1 to 30 µm is obtained. If the final thickness is less than 0.1 µm, it may be difficult for the encapsulating material cured product 80 to fully function as an insulating film. If the final thickness exceeds 30 µm, it may be difficult to obtain a fine pattern. Moreover, processing may take time, so that the throughput may decrease. The prebaking temperature employed when prebaking the organic resin composition is not particularly limited, but is preferably 50 to 150°C, and particularly preferably 60 to 130°C.

[9] The first insulating layer 90 is exposed and developed to form openings 91 at positions corresponding to the terminals (not illustrated in the drawings) of the electronic parts 40 (FIG. 7(c)).

A mechanism by which the openings 91 are formed by exposing and developing the positive-type photosensitive resin composition is described below. When actinic rays are applied to the film formed on the encapsulating material cured product 80 via a mask using an exposure system (e.g., stepper), an exposed area and an unexposed area are formed. The diazoquinone compound included in the unexposed area is insoluble in a developer, and is provided with resistance to the developer as a result of interaction with a polyimide resin or a polyamide resin (e.g., polybenzoxazole resin). The diazoquinone compound included in the exposed area chemically changes due to the actinic rays, and becomes soluble in the developer, so that dissolution of the resin is promoted. The openings 91 can be formed by dissolving and removing the exposed area utilizing the difference in solubility between the exposed area and unexposed area.

The exposure method is not particularly limited. For example, a mask having openings at positions corresponding to the openings 91 may be aligned with the first insulating layer 90, and actinic rays such as X-rays, electron beams, ultraviolet rays, or visible rays may be applied. The wavelength of the actinic rays is preferably 200 to 500 nm. It is preferable to use an i-line or a g-line.

The openings 91 are obtained by removing (dissolving) the exposed area using the developer. The developer is not particularly limited. Examples of the developer include a solvent and an alkaline aqueous solution. It is preferable to use an alkaline aqueous solution that has a small environmental impact. Examples of the alkaline aqueous solution include an aqueous solution of an alkali such as an inorganic alkali (e.g., sodium hydroxide, potassium hydroxide, sodium carbonate, sodium silicate, sodium metasilicate, or aqueous ammonia), a primary amine (e.g., ethylamine or n-propylamine), a secondary amine (e.g., diethylamine or di-n-propylamine), a tertiary amine (e.g., triethylamine or methyldiethylamine) an alcohol amine (e.g., dimethylethanolamine or triethanolamine), or a quaternary ammonium salt (e.g., tetramethylammonium hydroxide or tetraethylammonium hydroxide), and an aqueous solution obtained by adding an appropriate amount of a water-soluble organic solvent such as an alcohol (e.g., methanol or ethanol) or a surfactant to the above aqueous solution. A spray method, a puddle method, an immersion method, an ultrasonic method, or the like may be used as the development method.

[10] A conductive layer 92 is formed to connect the first insulating layer 90, the wall surface of the openings 91, and the terminals of the electronic parts 40 (FIG. 7(d)).

The conductive layer 92 may be formed by an arbitrary method. For example, the conductive layer 92 may be formed by sputtering a metal such as Cr, Ti, or Cu.

[11] A resist layer 100 is formed to have openings in areas in which conductors 93 are formed (FIG. 7(e)).

The resist layer 100 may be formed using an arbitrary resist material. For example, a liquid or film-shaped photosensitive resist material may be used. When using a liquid photosensitive resist material, a liquid photosensitive resist is formed by screen printing or the like to cover the entire conductive layer 92, exposed via a mask having openings in areas where the conductors 93 are formed, and developed using a developer to form the resist 100. When using a film-shaped photosensitive resist material, a film-shaped photosensitive resist is formed by laminating or the like to cover the entire conductive layer 92, and subjected to the same steps as described above to form the resist 100.

[12] The conductor 93 is formed in each opening of the resist 100 by plating (FIG 7(f)).

A metal that forms the conductor 93 is not particularly limited. It is preferable to use copper due to low electrical resistance and a capability to increase the signal speed.

[13] The resist 100 is removed, and the conductor layer 92 is removed in an area other than the area in which the conductor 93 is formed (FIG. 8(a)).

The conductive layer 92 may be removed by an arbitrary method. For example, the conductive layer 92 may be removed by reactive ion etching (RIE) or the like so that a residue of the conductive layer 92 rarely remain in an area in which the conductor 93 is not formed. The thickness of the conductor 93 is reduced when removing the conductive layer 92 by reactive ion etching or the like. However, since the conductor 93 is formed to have a thickness larger than that of the conductive layer 92, the conductor 93 is nor removed completely.

[14] A second insulating layer 110 is formed to cover the conductor 93 (FIG. 8(b)).

The second insulating layer 110 may be formed of an arbitrary material using an arbitrary method. The second insulating layer 110 may be formed in the same manner as the first insulating layer 90.

[15] Openings 111 are formed in the second insulating layer 110 in areas in which bumps 120 are formed (FIG. 8(c)).

The openings 111 may be formed in the second insulating layer 110 using an arbitrary method. The openings 111 may be formed in the same manner as in the case of forming the first insulating layer 90.

[16] The bumps 120 are formed in the openings 111 of the second insulating layer 110 (FIG. 8(d)).

The bumps 120 may be formed of an arbitrary material. It is preferable that the bumps 120 be formed of an alloy of at least two metals selected from the group consisting of tin (Sn), lead (Pb), silver (Ag), bismuth (Bi), indium (In), zinc (Zn), nickel (Ni), antimony (Sb), iron (Fe), aluminum (Al), gold (Au), germanium (Ge), and copper (Cu), or be formed of tin. It is preferable that the bumps 120 be formed of an Sn alloy such as an Sn-Pb alloy, an Sn-Bi alloy (lead-free alloy), an Sn-Ag-Cu alloy, an Sn-In alloy, or an Sn-Ag alloy taking account of the melting temperature and the mechanical properties.

The bumps 120 may be formed by an arbitrary method. For example, the bumps 120 may be formed by applying a paste that mainly includes an Sn alloy and flux to the openings 111 of the second insulating film 110 by screen printing or the like, and subjecting the paste to a solder reflow system, or placing a solder ball formed of an Sn alloy in the openings 111 of the second insulating layer 110, applying flux is applied to each solder ball, and subjecting each solder ball to a solder reflow system.

A step that dices (divides) the encapsulating material cured product 80 on which the wiring layer has been formed is described below with reference to FIGS. 8(d) and 8(e).

[17] The encapsulating material cured product 80 on which the bumps 120 have been formed are divided (diced) (FIGS. 8(d) and 8(e)).

The encapsulating material cured product 80 may be diced corresponding to each electronic part 40 or a plurality of electronic parts 40. A plurality of electronic parts 40 that differ in function can be incorporated in one electronic device 30 by dicing the encapsulating material cured product 80 corresponding to a plurality of electronic parts 40. In this case, the performance of the electronic device 30 can be improved.

The encapsulating material cured product 80 may be diced by an arbitrary method. For example, the encapsulating material cured product 80 may be diced using a laser or a dicing saw. It is preferable to dice the encapsulating material cured product 80 using a dicing saw since the encapsulating material cured product 80 can be diced easily.

Since the electronic device 30 thus obtained allows wires to be provided outside the outer edge of the electronic parts 40 to increase the number of I/O wires, it is possible to improve the performance of the electronic device 30. Since the thermally decomposable immobilizing resin layer 60 is used when immobilizing the electronic parts 40 on the support substrate 50, a residue of the immobilizing resin layer 60 rarely adheres to the side 41 of the encapsulating material cured product 80. This makes it possible to provide a highly reliable electronic device 30.

### Method of producing electronic device package

A step that mounts the diced electronic device 30 on the substrate is described below with reference to FIG 1.
[18] In the step that mounts the electronic device 30 on the substrate, each bump 18 of the electronic device 30 is connected to the wiring circuit 19 formed on the interposer 20 (FIG 1).

Each bump 18 may be connected to the wiring circuit 19 by an arbitrary method. For example, when at least the surface of each bump 18 is provided with a solder layer, flux is applied to each bump 18, and the electronic device 30 is placed on the interposer 20 so that each bump 18 corresponds to the wiring circuit 19, and then subjected to a solder reflow device. The electronic device 30 and the interposer 20 are electrically connected due to bonding between each bump 18 and the wiring circuit 19.

The electronic device package 10 is thus obtained.

### EXAMPLES

### Example 1

### Synthesis of polycarbonate

A reaction vessel was charged with 30.43 g (0.262 mol) of 1,3-cyclohexanediol, 23.02 g (0.147 mol) of endo,endo-2,3-norbomanedimethanol, 84.63 g (0.395 mol) of diphenyl carbonate, and 0.0163 g (0.0021 mol) of lithium carbonate. The reaction vessel was immersed in a heating bath heated at 120°C in a nitrogen atmosphere. The raw materials were dissolved in the solvent with stirring, and the solution was stirred for a further 2 hours (first step). After reducing the pressure inside the reaction vessel to 10 kPa, the solution was stirred at 120°C for 1 hour (second step). After reducing the pressure inside the reaction vessel to 0.5 kPa, the solution was stirred at 120°C for 1.5 hours (third step). After increasing the temperature of the heating bath to 180°C over about 30 minutes while maintaining the pressure inside the reaction vessel at 0.5 kPa, the solution was stirred at 180°C for 1 hour (fourth step). Note that phenol produced in the second to fourth steps was evaporated from the reaction vessel.
After returning the pressure inside the reaction vessel to normal pressure, 600 ml of tetrahydrofuran was added to dissolve the product The solution of the product was added dropwise to 6.01 of a mixture of isopropanol and water (=9/1 (v/v)) with stirring. The resulting precipitate was collected by suction filtration, washed with 3.01 of a mixture of isopropanol and water (=9/1 (v/v)), and collected by suction filtration.
The precipitate thus collected was dried at 60°C for 18 hours using a vacuum dryer to obtain 49.27 g of a polycarbonate resin powder (1,3-polycyclohexane carbonate resin/endo-polynorbomene carbonate resin).

### Preparation of temporary immobilizing material

100.0 g of the polycarbonate resin and 2.0 g of a photoacid generator "GSID26-1" (manufactured by BASF Japan Ltd.) were dissolved in 198.0 g of γ-butyrolactone to prepare a temporary immobilizing material having a resin component concentration of 33 wt%.

### Production of electronic part

The temporary immobilizing material was spin-coated onto a glass wafer (diameter: 200 mm), and soft-baked at 120°C for 5 minutes and at 220°C for 5 minutes in air to obtain a temporary immobilizing material layer having a thickness of 5 µm. A bare silicon chip (length: 10.5 mm, width: 10.5 mm, thickness: 725 µm) was immobilized on the temporary immobilizing material layer by applying a load of 1 kgf for 3 seconds at 140°C using a flip-chip bonder ("FCB3" manufactured by Panasonic Corporation). A encapsulating resin ("EME-7730" manufactured by Sumitomo Bakelite Co., Ltd.) was molded on the chip and the temporary immobilizing material layer using a compression molding machine so that the entirety of the chip was covered with the encapsulating resin. The encapsulating resin was molded at a temperature of 125°C 7 hours under a pressure of 3.9 MPa. The encapsulating resin was then cured at 175°C for 8 hours in air to obtain a encapsulating resin cured product.

An i-line was applied to the laminate of the glass wafer, the temporary immobilizing material, and the encapsulating resin cured product through the glass wafer at a dose of 2000 mJ/cm² (i-line). The laminate was placed between heating plates (150°C), and sucked under vacuum. The encapsulating resin cured product was then horizontally slid over 3 minutes to remove the encapsulating resin cured product from the glass wafer. A residue remaining on the encapsulating resin cured product and the glass wafer was removed by immersing the encapsulating resin cured product and the glass wafer in γ-butyrolactone for 5 minutes with shaking.

### INDUSTRIAL APPLICABILITY

According to the embodiments of the invention, it is possible to produce a redistribution-type electronic device that prevents displacement of electronic parts, and prevents a situation in which a residue of an adhesive layer adheres to a encapsulating material cured product in which the electronic parts are disposed. Therefore, an electronic device with high reliability can be obtained.

### REFERENCE SIGNS LIST

- 10: Electronic device package
- 11: Semiconductor chip
- 12: Functional surface
- 13: Encapsulating section
- 14: First insulating film
- 15: Via hole
- 16: Conductor layer
- 17: Second insulating film
- 18: Bump
- 19: Wiring circuit
- 20: Interposer
- 30: Electronic device
- 40: Electronic part
- 41: Side
- 42: Space formed between adjacent electronic parts
- 50: Support substrate
- 60: Immobilizing resin layer
- 70: Encapsulating material layer
- 71: Encapsulating material cured product layer
- 80: Encapsulating material cured product
- 90: First insulating layer
- 91: Opening
- 92: Conductive layer
- 93: Conductor
- 100: Resist layer
- 110: Second insulating layer
- 111: Opening
- 120: Bump

## Claims

1. A method of producing an electronic device comprising:
an immobilizing resin layer-forming step that includes forming an immobilizing resin layer on a surface of a support substrate;
an electronic part-immobilizing step that includes disposing a plurality of electronic parts on the immobilizing resin layer so that a space is formed between adjacent electronic parts among the plurality of electronic parts to immobilize the plurality of electronic parts on the support substrate via the immobilizing resin layer;
a encapsulating material layer-forming step that includes covering the plurality of electronic parts with a encapsulating material to form a encapsulating material layer on the immobilizing resin layer and the plurality of electronic parts;
a encapsulating material-curing step that includes curing the encapsulating material by heating the encapsulating material to obtain a encapsulating material cured product which is supported on the support substrate and in which the plurality of electronic parts are disposed; and
a removal step that includes removing the encapsulating material cured product supported on the support substrate from the support substrate,
the removal step removing the encapsulating material cured product from the support substrate by reducing a molecular weight of a resin included in the immobilizing resin layer.

2. The method of producing an electronic device according to claim 1,
wherein the removal step includes removing the encapsulating material cured product from the support substrate by heating the immobilizing resin layer to thermally decompose the immobilizing resin layer.

3. The method of producing an electronic device according to claim 1,
wherein the removal step includes applying active energy rays to the immobilizing resin layer, and removing the encapsulating material cured product from the support substrate by heating the immobilizing resin layer to thermally decompose the immobilizing resin layer.

4. The method of producing an electronic device according to claim 1,
wherein the removal step includes applying active energy rays to the immobilizing resin layer, and removing the encapsulating material cured product from the support substrate by heating the immobilizing resin layer to melt the immobilizing resin layer.

5. The method of producing an electronic device according to any one of claims I to 4,
wherein a temperature at which the encapsulating material is heated in the encapsulating material-curing step is lower than a temperature at which the immobilizing resin layer is heated in the removal step.

6. The method of producing an electronic device according to claim 3 or 4,
wherein the temperature at which the immobilizing resin layer is heated in the removal step is 130 to 200°C.

7. The method of producing an electronic device according to claim 4,
wherein the immobilizing resin layer to which the active energy rays have been applied has a melt viscosity at 180°C of 0.01 to 100 Pa·s.

8. A method of producing an electronic device comprising:
an immobilizing resin layer-forming step that includes forming an immobilizing resin layer on a surface of a support substrate;
an electronic part-immobilizing step that includes disposing a plurality of electronic parts on the immobilizing resin layer so that a space is formed between adjacent electronic parts among the plurality of electronic parts to immobilize the plurality of electronic parts on the support substrate via the immobilizing resin layer;
a encapsulating material layer-forming step that includes covering the plurality of electronic parts with a encapsulating material to form a encapsulating material layer on the immobilizing resin layer and the plurality of electronic parts; and
a encapsulating material-curing/removal step that includes curing the encapsulating material by heating the encapsulating material to obtain a encapsulating material cured product which is supported on the support substrate and in which the plurality of electronic parts are disposed, and removing the encapsulating material cured product from the support substrate,
the encapsulating material-curing/removal step removing the encapsulating material cured product from the support substrate by reducing a molecular weight of a resin included in the immobilizing resin layer.

9. The method of producing an electronic device according to claim 8,
wherein the encapsulating material-curing/removal step includes removing the encapsulating material cured product from the support substrate by heating the immobilizing resin layer to thermally decompose the immobilizing resin layer.

10. The method of producing an electronic device according to claim 8,
wherein the encapsulating material-curing/removal step includes applying active energy rays to the immobilizing resin layer, and removing the encapsulating material cured product from the support substrate by heating the immobilizing resin layer to thermally decompose the immobilizing resin layer.

11. The method of producing an electronic device according to claim 8,
wherein the encapsulating material-curing/removal step includes applying active energy rays to the immobilizing resin layer, and removing the encapsulating material cured product from the support substrate by heating the immobilizing resin layer to melt the immobilizing resin layer.

12. The method of producing an electronic device according to claim 10 or 11,
wherein the temperature at which the encapsulating material and the immobilizing resin layer are heated in the encapsulating material-curing/removal step is 130 to 200°C.

13. The method of producing an electronic device according to claim 11,
wherein the immobilizing resin layer to which the active energy rays have been applied has a melt viscosity at 180°C of 0.01 to 100 Pa-s.

14. The method of producing an electronic device according to any one of claims 1 to 13, further comprising:
a wiring layer-forming step that includes forming a wiring layer on a side of the encapsulating material cured product on which the plurality of electronic parts are exposed to obtain the encapsulating material cured product on which the wiring layer is formed.

15. The method of producing an electronic device according to claim 14, further comprising:
a dicing step that includes dicing the encapsulating material cured product on which the wiring layer is formed.

16. The method of producing an electronic device according to claim 3 or 10,
wherein the immobilizing resin layer includes a resin that decreases in thermal decomposition temperature in the presence of an acid or a base, and a photoacid generator that generates an acid upon application of the active energy rays or a photobase generator that generates a base upon application of the active energy rays.

17. The method of producing an electronic device according to claim 4 or 11,
wherein the immobilizing resin layer includes a resin that decreases in melting temperature in the presence of an acid or a base, and a photoacid generator that generates an acid upon application of the active energy rays or a photobase generator that generates a base upon application of the active energy rays.

18. The method of producing an electronic device according to claim 16 or 17,
wherein the resin is a polycarbonate resin.

19. The method of producing an electronic device according to claim 18,
wherein the polycarbonate resin includes a carbonate structural unit that includes at least two cyclic structures.

20. An electronic device produced by the method of producing an electronic device according to any one of claims 1 to 19.

21. A method of producing an electronic device package comprising mounting the diced encapsulating material cured product according to claim 15 on a substrate.

22. An electronic device package produced by the method of producing an electronic device package according to claim 21.
